(19) Europäisches Patentamt
European Patent Office
Office européen des brevets

(11) **EP 2 317 511 B1**

(12) **EUROPÄISCHE PATENTSCHRIFT**

(45) Veröffentlichungstag und Bekanntmachung des Hinweises auf die Patenterteilung:
**07.03.2012 Patentblatt 2012/10**

(51) Int Cl.:
***G11B 7/245*** *(2006.01)* ***G03F 7/027*** *(2006.01)*
***G03H 1/00*** *(2006.01)* ***G11B 7/24*** *(2006.01)*

(21) Anmeldenummer: **09013771.2**

(22) Anmeldetag: **03.11.2009**

(54) **Photopolymerformulierungen mit einstellbarem mechanischem Modul Guv**

Photopolymer formulations with adjustable mechanical module Guv

Formules de photopolymères dotées d'un module mécanique réglable Guv

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(43) Veröffentlichungstag der Anmeldung:
**04.05.2011 Patentblatt 2011/18**


(73) Patentinhaber: **Bayer MaterialScience AG**
**51368 Leverkusen (DE)**

(72) Erfinder:
- **Weiser, Marc-Stephen**
  **51379 Leverkusen (DE)**
- **Rölle Thomas**
  **51381 Leverkusen (DE)**
- **Bruder, Friedrich-Karl**
  **47802 Krefeld (DE)**
- **Fäcke, Thomas**
  **51375 Leverkusen (DE)**
- **Hönel, Dennis**
  **53909 Zülpich-Wichterich (DE)**


(56) Entgegenhaltungen:
**US-A- 5 725 970 US-A1- 2005 013 959**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 317 511 B1

Printed by Jouve, 75001 PARIS (FR)

## Beschreibung

Gegenstand der Erfindung ist ein Verfahren zur Herstellung von belichteten, holographischen Medien enthaltend eine Photopolymer-Formulierung. Ein weiterer Gegenstand der Erfindung ist ein belichtetes holographisches Medium, das nach dem erfindungsgemäßen Verfahren erhältlich ist.

In der WO 2008/125229 A1 sind Photopolymer-Formulierungen beschrieben, die zur Herstellung von holographischen Medien verwendet werden können. Die offenbarten Photopolymer-Formulierungen umfassen Polyurethanbasierte Matrixpolymere, Schreibmomomere auf Acrylbasis sowie Photoinitiatoren. Die mit Hilfe der Photopolymer-Formulierungen erhältlichen holographischen Medien zeichnen sich durch eine hohe Helligkeit aus, was physikalisch durch deren hohen Brechungsindexkontrast ($\Delta n$) beschrieben wird.

Bei dem bekannten Verfahren ist es nicht möglich, die mechanischen Eigenschaften der erhaltenen belichteten holographischen Medien bei im Wesentlichen gleichbleibendem $\Delta n$ zu variieren. So verändert sich hier bei einer Modifizierung dieser Eigenschaften durch Veränderung der chemischen Zusammensetzung auch der $\Delta n$ Wert. Eine Variation der mechanischen Eigenschaften ohne nennenswerte Veränderung des Brechungsindexkontrastes ist jedoch in vielen Fällen wünschenswert, da je nach Einsatzgebiet an holographische Medien ganz unterschiedliche Anforderungen bezüglich der Mechanik gestellt werden. So können beispielsweise Medien mit einem mechanischen Modul von weniger als 0.7 MPa ohne zusätzlichen Klebstoff auf ein Substrat laminiert werden. Auf der anderen Seite kann es wünschenswert sein, Medien zu erhalten, die unempfindlich gegen Beschädigungen durch äußere Einflüsse sind. Dies kann dann gewährleistet werden, wenn die Medien einen hohen Modul im Bereich von 15 MPa und mehr aufweisen.

Weiterhin ist es insbesondere im Bereich der Verwendung von Hologrammen als Sicherheitsmerkmal von entscheidender Bedeutung, die mechanischen Eigenschaften je nach Wunsch einstellen zu können, ohne dass sich dabei gleichzeitig der An Wert nennenswert ändert. So kann es gerade erstrebenswert sein, dass ein belichtetes holographisches Medium nicht zerstörungsfrei von einem gekennzeichneten Produkt, wie einem Ausweisdokument, entfernt werden kann. Hierfür sind Medien mit einer weichgummartigen Konsistenz geeignet, die einen entsprechenden niedrigen Modul im Bereich von weniger als 0.7 MPa aufweisen. Umgekehrt kann es aber auch gerade notwendig sein, einen zerstörungsfreien Transfer zu ermöglichen. In diesem Fall sollte das Medium eine höhere Steifigkeit aufweisen, was einem Modul im Bereich von 15 MPa und mehr entspricht. Diese verschiedenen Aspekte können mit dem im Stand der Technik bekannten Verfahren nicht realisiert werden.

Aufgabe der vorliegenden Erfindung war es daher, ein Verfahren zur Herstellung von belichteten holographischen Medien bereit zu stellen, mit dessen Hilfe Medien mit einem im Bereich zwischen 0,1 und 160 MPa variablen Modul $G_{UV}$ und einem $\Delta n \geq 0{,}008$ erhalten werden können.

Diese Aufgabe wird durch ein Verfahren gelöst, bei dem

i) eine Photopolymer-Formulierung umfassend,

  A) Matrixpolymere als amorphes Netzwerk

  B) eine Kombination eines monofunktionellen Schreibmonomers und eines multifunktionellen Schreibmonomers

  C) ein Photoinitiatorsystem

  D) optional eine nicht photopolymerisierbare Komponente

  E) gegebenenfalls Katalysatoren, Radikalstabilisatoren, Lösungsmittel, Additive sowie andere Hilfs- und / oder Zusatzstoffe

bereitgestellt,

ii) die Photopolymer-Formulierung in die Form von Medien gebracht

iii) die Medien einem holographischen Belichtungsexperiment unterzogen werden, um das Hologramm zu schreiben und

iv) das Medium als ganzes mit UV-Strahlung belichtet wird um das Hologramm zu fixieren

wobei es sich bei den Schreibmonomeren um Acrylat- und / oder Methacrylat-funktionalisierte Verbindungen handelt, der Gesamtgehalt an Schreibmonomeren in der Photopolymer-Formulierung ≥ 30 Gew.-% und ≤ 45 Gew.-% ist, die unbelichtete Photopolymer-Formulierung einen Modul $G_0 < 0{,}7$ MPa aufweist und der Modul $G_{UV}$ der belichteten Photopolymer Formulierung im vorgesehenen Bereich zwischen 0,1 und 160 MPa über das Verhältnis des relativen Anteils des monofunktionellen Schreibmonomers zu dem relativen Anteil des multifunktionellen Schreibmonomer am Gesamtschreibmonomergehalt derart eingestellt wird, dass ein hoher Modul durch einen hohen relativen Anteil des multifunktionellen Schreibmonomers und ein niedriger Modul durch einen hohen relativen Anteil des monofunktionellen Schreibmonomers am Gesamtschreibmonomergehalt realisiert wird.

Mit Hilfe des erfindungsgemäßen Verfahrens können holographische Medien erhalten werden, die nach dem Belichten mit UV-Strahlung einen mechanischer Modul $G_{UV}$ im Bereich zwischen 0,1 und 160 MPa aufweisen. Es ist also möglich, je nach gewünschtem Anwendungsprofil Medien mit definierten Moduli im genannten Bereich herzustellen, die sich in ihrem Brechungsindexkontrast $\Delta n$ kaum unterscheiden. Dies hat für den Hersteller der Photopolymerformulierungen den Vorteil, dass mit einer begrenzten Anzahl von geeigneten Komponenten Photopolymerformulierungen bereitgestellt werden können, die unterschiedlichen Anforderungen hinsichtlich ihrer Applikation und ihres Gebrauchs, in denen der mechanische Modul entscheidend ist, gerecht werden, ohne das vom Endanwender Kompromisse in der Helligkeit der Hologramme hingenommen werden müssen.

Insbesondere können die belichteten, holographischen Medien einen Modul $G_{UV}$ im Bereich zwischen 0,3 und 40, bevorzugt zwischen 0,7 und 15 MPa aufweisen.

Gemäß einer bevorzugten Ausführungsform der Erfindung ist vorgesehen, dass die Schreibmonomere und die Matrixpolymere so ausgewählt werden, dass der Brechungsindex jedes der beiden Schreibmonomere entweder um mindestens 0,05 Einheiten größer als der Brechungsindex der Matrixpolymere oder der Brechungsindex jedes der beiden Schreibmonomere mindestens um 0,05 Einheiten kleiner als der Brechungsindex der Matrixpolymere ist.

Die Matrixpolymere können vorzugsweise Polyurethane sein. Die Polyurethane sind insbesondere durch Umsetzung einer NCO-Gruppen tragenden Komponente und einer NCO-reaktiven Komponenten herstellbar, wobei mindestens eine der beiden Komponenten ein Equivalentgewicht von mehr als 200 g/Mol, bevorzugt von mehr als 350 g/Mol aufweist und weiterhin bevorzugt im Polymerrückgrat keine zyklischen Strukturen auftreten. Besonders bevorzugt sind Polyurethane, die im ausreagierten Zustand eine Glastemperatur $T_G$ < -45°C aufweisen.

Bei den Matrixpolymeren A) kann es sich vorzugsweise um Polyurethane handeln, die insbesondere durch Umsetzung von einer Isocyanatkomponente a) mit einer Isocyanat-reaktiven Komponente b) erhältlich sind.

Die Isocyanatkomponente a) umfasst bevorzugt Polyisocyanate. Als Polyisocyanate können alle dem Fachmann an sich bekannten Verbindungen oder deren Mischungen eingesetzt werden, die im Mittel zwei oder mehr NCO-Funktionen pro Molekül aufweisen. Diese können auf aromatischer, araliphatischer, aliphatischer oder cycloaliphatischer Basis sein. In untergeordneten Mengen können auch Monoisocyanate und/oder ungesättigte Gruppen enthaltende Polyisocyanate mitverwendet werden.

Beispielsweise geeignet sind Butylendiisocyanat, Hexamethylendiisocyanat (HDI), Isophorondiisocyanat (IPDI), 1,8-Diisocyanato-4-(isocyanatomethyl)octan, 2,2,4- und/oder 2,4,4-Trimethylhexamethylendiisocyanat, die isomeren Bis-(4,4'-isocyanatocyclohexyl)methan und deren Mischungen beliebigen Isomerengehalts, Isocyanatomethyl-1,8-octandiisocyanat, 1,4-Cyclohexylendiisocyanat, die isomeren Cyclohexandimethylendiisocyanate, 1,4-Phenylendiisocyanat, 2,4- und/oder 2,6-Toluylendiisocyanat 1,5-Naphthylendiisocyanat, 2,4'- oder 4,4'-Diphenylmethandiisocyanat und/oder Triphenylmethan-4,4',4"-triisocyanat.

Ebenfalls möglich ist der Einsatz von Derivaten monomerer Di- oder Triisocyanate mit Urethan-, Harnstoff, Carbodiimid-, Acylharnstoff-, Isocyanurat-, Allophanat-, Biuret-, Oxadiazintrion-, Uretdion- und/oder Iminooxadiazindionstrukturen.

Bevorzugt ist der Einsatz von Polyisocyanaten auf Basis aliphatischer und/oder cycloaliphatischer Di- oder Triisocyanate.

Besonders bevorzugt handelt es sich bei den Polyisocyanaten der Komponente a) um di- oder oligomerisierte aliphatische und/oder cycloaliphatische Di- oder Triisocyanate.

Ganz besonders bevorzugt sind Isocyanurate, Uretdione und/oder Iminooxadiazindione basierend auf HDI sowie 1,8-Diisocyanato-4-(isocyanatomethyl)octan oder deren Mischungen.

Ebenfalls können als Komponente a) NCO-funktionelle Prepolymere mit Urethan-, Allophanat-, Biuret- und/oder Amidgruppen eingesetzt werden. Prepolymere der Komponente a) werden in dem Fachmann an sich gut bekannter Art und Weise durch Umsetzung von monomeren, oligomeren oder Polyisocyanaten a1) mit isocyanatreaktiven Verbindungen a2) in geeigneter Stöchiometrie unter optionalem Einsatz von Katalysatoren und Lösemitteln erhalten.

Als Polyisocyanate a1) eignen sich alle dem Fachmann an sich bekannten aliphatischen, cycloaliphatischen, aromatischen oder araliphatischen Di- und Triisocyanate, wobei es unerheblich ist, ob diese mittels Phosgenierung oder nach phosgenfreien Verfahren erhalten wurden. Daneben können auch die diem Fachmann an sich gut bekannten höhermolekularen Folgeprodukte monomerer Di- und/oder Triisocyanate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur jeweils einzeln oder in beliebigen Mischungen untereinander eingesetzt werden.

Beispiele für geeignete monomere Di- oder Triisocyanate, die als Komponente a1) eingesetzt werden können, sind Butylendiisocyanat, Hexamethylendiisocyanat (HDI), Isophorondiisocyanat (IPDI), Trimethyl-hexamethylen-diisocyanat (TMDI), 1,8-Diisocyanato-4-(isocyanatomethyl)-octan, Isocyanatomethyl-1,8-octandiisocyanat (TIN), 2,4- und/ oder 2,6-Toluen-diisocyanat.

Als isocyanatreaktive Verbindungen a2) zum Aufbau der Prepolymere werden bevorzugt OH-funktionelle Verbindungen eingesetzt. Diese sind analog den OH-funktionellen Verbindungen wie sie nachfolgend für die Komponente b) beschrieben sind.

Bevorzugte OH-funktionelle Verbindungen in a2) sind Polyester- und/oder Polyetherpolyole mit zahlenmittleren Molmassen von 200 bis 6200 g/Mol. Besonders bevorzugt sind difunktionelle Polyetherpolyole basierend auf Ethylenglykol und Propylenglykol, wobei der Propylenglykolanteil mindestens 40 Gew.-% ausmacht, sowie Polymere des Tetrahydrofurans mit zahlenmittleren Molmassen von 200 bis 4100 g/Mol sowie aliphatische Polyesterpolyole mit zahlenmittleren Molmassen von 200 bis 3100 g/Mol.

Ganz besonders bevorzugt sind difunktionelle Polyetherpolyole basierend auf Ethylenglykol und Propylenglykol, wobei der Propylenglykolanteil mindestens 80 Gew.-% ausmacht (insbesondere reine Polypropylenglykole), sowie Polymere des Tetrahydrofurans mit zahlenmittleren Molmassen von 200 bis 2100 g/Mol. Ganz besonders bevorzugt sind ebenso Additionsprodukte von Butyrolacton, ε-Caprolacton und/oder Methyl-ε-caprolacton (insbesondere ε-Caprolacton) an 2 bis 20 Kohlenstoffatome enthaltende aliphatische, araliphatische oder cycloaliphatische di-, tri- oder polyfunktionelle Alkohole (insbesondere an difunktionelle aliphatische Alkohole mit 3 bis 12 Kohlenstoffatomen). Diese Additionsprodukte haben bevorzugt zahlenmittlere Molmassen von 200 bis 2000 g/Mol, besonders bevorzugt von 500 bis 1400 g/Mol.

Allophanate können auch im Gemisch mit anderen Prepolymeren oder Oligomeren der Komponente a1) eingesetzt werden. In diesen Fällen ist der Einsatz von OH-funktionellen Verbindungen mit Funktionalitäten von 1 bis 3,1 vorteilhaft. Beim Einsatz monofunktioneller Alkohole sind solche mit 3 bis 20 Kohlenstoffatomen bevorzugt.

Ebenfalls möglich ist der Einsatz von Aminen zur Prepolymerherstellung. Beispielsweise geeignet sind Ethylendiamin, Diethylentriamin, Triethylentetramin, Propylendiamin, Diaminocyclohexan, Diaminobenzol, Diaminobisphenyl, difunktionelle Polyamine wie z.B. die Jeffamine®, aminterminierte Polymere mit zahlenmittleren Molmassen bis 10000 g/Mol oder deren beliebige Gemische untereinander.

Zur Herstellung von biuretgruppenhaltigen Prepolymeren wird Isocyanat im Überschuss mit Amin umgesetzt, wobei eine Biuretgruppe entsteht. Als Amine eignen sich in diesem Falle für die Umsetzung mit den erwähnten Di-, Tri- und Polyisocyanaten alle oligomeren oder polymeren, primären oder sekundären, difunktionellen Amine der vorstehend genannten Art. Bevorzugt sind aliphatische Biurete auf Basis aliphatischer Amine und aliphatischer Isocyanate. Besonders bevorzugt sind niedermolekulare Biurete mit zahlenmittleren Molmassen kleiner 2000 g/Mol basierend auf aliphatischer Diaminen oder difunktionellen Polyaminen und aliphatischen Diisocyanaten, insbesondere HDI und TMDI.

Bevorzugte Prepolymere sind Urethane, Allophanate oder Biurete aus aliphatischen Isocyanat-funktionellen Verbindungen und oligomeren oder polymeren Isocyanat-reaktiven Verbindungen mit zahlenmittleren Molmassen von 200 bis 10000 g/Mol, besonders bevorzugt sind Urethane, Allophanate oder Biurete aus aliphatischen Isocyanat-funktionellen Verbindungen und Polyolen mit zahlenmittleren Molmassen von 200 bis 6200 g/Mol oder (Poly-)Aminen mit zahlenmittleren Molmassen kleiner 3000 g/Mol und ganz besonders bevorzugt sind Allophanate aus HDI oder TMDI und difunktionellen Polyetherpolyolen (insbesondere Polypropylenglykolen) mit zahlenmittleren Molmassen von 200 bis 2100 g/Mol, Urethane aus HDI oder TMDI auf Basis von Additionsprodukten von Butyrolacton, ε-Caprolacton und/oder Methyl-ε-caprolacton (insbesondere ε-Caprolacton) an 2 bis 20 Kohlenstoffatome enthaltende aliphatische, araliphatische oder cycloaliphatische di-, tri- oder polyfunktionelle Alkohole (insbesondere an difunktionelle aliphatische Alkohole mit 3 bis 12 Kohlenstoffatomen) mit zahlenmittleren Molmassen von 500 bis 3000 g/Mol, insbesondere bevorzugt von 1000 bis 2000 g/Mol (insbesondere im Gemisch mit anderen Oligomeren difunktioneller aliphatischer Isocyanate) oder Urethane aus HDI oder TMDI auf Basis trifunktioneller Polyetherpolyole (insbesondere Polypropylenglykol) mit zahlenmittleren Molmassen zwischen 2000 und 6200 g/Mol sowie Biurete aus HDI oder TMDI mit difunktionellen Aminen oder Polyaminen mit zahlenmittleren Molmassen von 200 bis 1400 g/Mol (insbesondere auch im Gemisch mit anderen Oligomeren difunktioneller aliphatischer Isocyanate).

Bevorzugt weisen die vorstehend beschriebenen Prepolymere Restgehalte an freiem monomeren Isocyanat von weniger als 2 Gew.-%, besonders bevorzugt weniger als 1,0 Gew.-%, ganz besonders bevorzugt weniger als 0,5 Gew.-% auf.

Selbstverständlich kann die Isocyanatkomponente anteilsmäßig neben den beschriebenen Prepolymeren weitere Isocyanatkomponenten enthalten. Hierfür kommen in Betracht aromatische, araliphatische, aliphatische und cycloaliphatische Di-, Tri- oder Polyisocyanate verwendet. Es können auch Mischungen solcher Di-, Tri- oder Polyisocyanate eingesetzt werden. Beispiele geeigneter Di-, Tri- oder Polyisocyanate sind Butylendiisocyanat, Hexamethylendiisocyanat (HDI), Isophorondiisocyanat (IPDI), 1,8-Diisocyanato-4-(isocyanatomethyl)octan, 2,2,4- und/oder 2,4,4-Trimethylhexamethylendiisocyanat (TMDI), die isomeren Bis(4,4'-isocyanatocyclohexyl)methane und deren Mischungen beliebigen Isomerengehalts, Isocyanatomethyl-1,8-octandiisocyanat, 1,4-Cyclohexylendiisocyanat, die isomeren Cyclohexandimethylendiisocyanate, 1,4-Phenylendiisocyanat, 2,4- und/oder 2,6-Toluylendiisocyanat, 1,5-Naphthylendiisocyanat, 2,4'- oder 4,4'-Diphenylmethandiisocyanat, Triphenylmethan-4,4',4''-triisocyanat oder deren Derivate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur und Mischungen derselben. Bevorzugt sind Polyisocyanate auf Basis oligomerisierter und/oder derivatisierter Diisocyanate, die durch geeignete Verfahren von überschüssigem Diisocyanat befreit wurden, insbesondere die des Hexamethylendiisocyanat. Besonders bevorzugt sind die oligomeren Isocyanurate, Uretdione und Iminooxadiazindione des HDI sowie deren Mischungen.

Es ist gegebenenfalls auch möglich, dass die Isocyanatkomponente a) anteilsmäßig Isocyanate enthält, die teilweise mit isocyanat-reaktiven ethylenisch ungesättigten Verbindungen umgesetzt sind. Bevorzugt werden hierbei als isocyanat-reaktives ethylenisch ungesättigten Verbindungen $\alpha,\beta$-ungesättigte Carbonsäurederivate wie Acrylate, Methacrylate, Maleinate, Fumarate, Maleimide, Acrylamide, sowie Vinylether, Propenylether, Allylether und Dicyclopentadienyl-Einheiten enthaltende Verbindungen, die mindestens eine gegenüber Isocyanaten reaktive Gruppe aufweisen, eingesetzt, besonders bevorzugt sind dies Acrylate und Methacrylate mit mindestens einer isocyanatreaktiven Gruppe. Als hydroxyfunktionelle Acrylate oder Methacrylate kommen beispielsweise Verbindungen wie 2-Hydroxyethyl(meth)acrylat, Polyethylenoxid-mono-(meth)acrylate, Polypropylenoxidmono(meth)acrylate, Polyalkylenoxidmono(meth)acrylate, Poly($\epsilon$-caprolacton)mono(meth)acrylate, wie z.B. Tone® M100 (Dow, USA), 2-Hydroxypropyl(meth)acrylat, 4-Hydroxybutyl(meth)acrylat, 3-Hydroxy-2,2-dimethylpropyl(meth)acrylat, die hydroxyfunktionellen Mono-, Di- oder Tetra(meth)acrylate mehrwertiger Alkohole wie Trimethylolpropan, Glycerin, Pentaerythrit, Dipentaerythrit, ethoxyliertes, propoxyliertes oder alkoxyliertes Trimethylolpropan, Glycerin, Pentaerythrit, Dipentaerythrit oder deren technische Gemische in Betracht. Darüberhinaus sind isocyanat-reaktive oligomere oder polymere ungesättigte Acrylat- und/oder Methacrylatgruppen enthaltende Verbindungen alleine oder in Kombination mit den vorgenannten monomeren Verbindungen geeignet. Der Anteil an Isocyanaten die teilweise mit isocyanat-reaktiven ethylenisch ungesättigten Verbindungen umgesetzt sind an der Isocyanatkomponente a) beträgt 0 bis 99 %, bevorzugt 0 bis 50 %, besonders bevorzugt 0 bis 25 % und ganz besonders bevorzugt 0 bis 15 %.

Es ist gegebenenfalls auch möglich, dass die vorgenannten Isocyanatkomponente a) vollständig oder anteilsmäßig Isocyanate enthält, die ganz oder teilweise mit dem Fachmann aus der Beschichtungstechnologie bekannten Blockierungsmitteln umgesetzt sind. Als Beispiel für Blockierungsmittel seien genannt: Alkohole, Lactame, Oxime, Malonester, Alkylacetoacetate, Triazole, Phenole, Imidazole, Pyrazole sowie Amine, wie z.B. Butanonoxim, Diisopropylamin, 1,2,4-Triazol, Dimethyl-1,2,4-triazol, Imidazol, Malonsäurediethylester, Acetessigester, Acetonoxim, 3,5-Dimethylpyrazol, $\epsilon$-Caprolactam, N-tert.-Butyl-benzylamin, Cyclopentanoncarboxyethylester oder beliebige Gemische dieser Blockierungsmittel.

Als Komponente b) können an sich alle polyfunktionellen, isocyanatreaktiven Verbindungen eingesetzt werden, die im Mittel wenigstens 1.5 isocyanatreaktive-Gruppen pro Molekül aufweisen.

Isocyanatreaktive Gruppen im Rahmen der vorliegenden Erfindung sind bevorzugt Hydroxy-, Amino- oder Thiogruppen, besonders bevorzugt sind Hydroxyverbindungen.

Geeignete polyfunktionelle, isocyanatreaktive Verbindungen sind beispielsweise Polyester-, Polyether-, Polycarbonat-, Poly(meth)acrylat- und/oder Polyurethanpolyole.

Daneben sind als Bestandteile der Komponente b) als polyfunktionelle, isocyanatreaktive Verbindungen auch niedermolekulare, d.h. mit Molekulargewichten kleiner 500 g/mol, kurzkettige, d.h. 2 bis 20 Kohlenstoffatome enthaltende aliphatische, araliphatische oder cycloaliphatische di, tri oder polyfunktionelle Alkohole geeignet.

Dies können beispielsweise sein Ethylenglykol, Diethylenglykol, Triethylenglykol, Tetraethylenglykol, Dipropylenglykol, Tripropylenglykol, 1,2-Propandiol, 1,3-Propandiol, 1,4-Butandiol, Neopentylglykol, 2-Ethyl-2-butylpropandiol, Trimethylpentandiol, stellungsisomere Diethyloctandiole, 1,3-Butylenglykol, Cyclohexandiol, 1,4-Cyclohexandimethanol, 1,6-Hexandiol, 1,2- und 1,4-Cyclohexandiol, hydriertes Bisphenol A (2,2-Bis(4-hydroxycyclohexyl)propan), 2,2-Dimethyl-3-hydroxypropionsäure (2,2-dimethyl-3-hydroxypropylester). Beispiele geeigneter Triole sind Trimethylolethan, Trimethylolpropan oder Glycerin. Geeignete höherfunktionelle Alkohole sind Ditrimethylolpropan, Pentaerythrit, Dipentaerythrit oder Sorbit.

Als Polyesterpolyole sind beispielsweise lineare Polyesterdiole oder verzweigte Polyesterpolyole geeignet, wie sie in bekannter Weise aus aliphatischen, cycloaliphatischen oder aromatischen Di- bzw. Polycarbonsäuren bzw. ihren Anhydriden mit mehrwertigen Alkoholen einer OH-Funktionalität $\geq 2$ erhalten werden.

Beispiele für solche Di- bzw. Polycarbonsäuren bzw. Anhydride sind Bernstein-, Glutar-, Adipin-, Pimelin-, Kork-, Azelain-, Sebacin-, Nonandicarbon-, Decandicarbon-, Terephthal-, Isophthal-, o-Phthal-, Tetrahydrophthal-, Hexahydrophthal- oder Trimellitsäure sowie Säureanhydride wie o-Phthal-, Trimellit- oder Bernsteinsäureanhydrid oder deren beliebige Gemische untereinander.

Beispiele für solche geeigneten Alkohole sind Ethandiol, Di-, Tri-, Tetraethylenglykol, 1,2-Propandiol, Di-, Tri-, Tetrapropylenglykol, 1,3-Propandiol, Butandiol-1,4, Butandiol-1,3, Butandiol-2,3, Pentandiol-1,5, Hexandiol-1,6, 2,2-Dimethyl-1,3-propandiol, 1,4-Dihydroxycyclohexan, 1,4-Dimethylolcyclohexan, Octandiol-1,8, Decandiol-1,10, Dodecandiol-1,12, Trimethylolpropan, Glycerin oder deren beliebige Gemische untereinander.

Bevorzugte Polyesterpolyole basieren auf aliphatischen Alkoholen und Mischungen aus aliphatischen und aromatischen Säuren und haben zahlenmittlere Molmassen zwischen 500 und 10000 g/Mol und Funktionalitäten zwischen 1,8 und 6,1.

Besonders bevorzugte Polyesterpolyole basieren auf aliphatischen Diolen wie Butan-1,4-diol, Hexan-1,6-diol, Neopentylglykol, Ethandiol, Propylenglykol, 1,3-Butylenglykol, Di-, Tri-, Polyethylenglykol, Di-, Tri- und/oder Tetrapropylenglykol oder Mischungen aus vorgenannten Diolen mit aliphatischen höherfunktionellen Alkoholen wie Trimethylolpropan und/oder Pentaerythrit, wobei der Anteil der höherfunktionellen Alkohole bevorzugt kleiner 50 Gewichtsprozent (insbesondere bevorzugt kleiner 30 Gewichtsprozent) bezogen auf die Gesamtmenge des eingesetzten Alkohols ausmacht, in Verbindung mit aliphatischen Di- bzw. Polycarbonsäuren bzw. Anhydriden wie Adipinsäure und/oder Bernsteinsäure oder Mischungen aus vorgenannten aliphatischen Polycarbonsäuren bzw. Anhydriden mit aromatischen Polycarbonsäuren bzw. Anhydriden wie Terephthalsäure und/oder Isophthalsäure wobei der Anteil der aromatischen Polycarbonsäuren bzw. Anhydride bevorzugt kleiner 50 Gewichtsprozent (insbesondere bevorzugt kleiner 30 Gewichtsprozent) bezogen auf die Gesamtmenge der eingesetzten Polycarbonsäuren bzw. Anhydride ausmacht. Besonders bevorzugte Polyesterpolyole haben zahlenmittlere Molmassen zwischen 1000 und 6000 g/Mol und Funktionalitäten zwischen 1,9 und 3,3.

Die Polyesterpolyole können auch auf natürlichen Rohstoffen wie Rizinusöl basieren. Ebenfalls möglich ist, dass die Polyesterpolyole auf Homo- oder Mischpolymerisaten von Lactonen basieren, wie sie bevorzugt durch Anlagerung von Lactonen bzw. Lactongemischen im Rahmen einer ringöffnenden Lacton-Polymerisation wie Butyrolacton, ε-Caprolacton und/oder Methyl-εcaprolacton an hydroxyfunktionelle Verbindungen wie mehrwertige Alkohole einer OH-Funktionalität ≥ 2 oder Polyole eine Funktionalität von größer 1,8 beispielsweise der vorstehend genannten Art erhalten werden können.

Bevorzugte Polyole, die hier als Starter eingesetzt werden, sind Polyetherpolyole einer Funktionalität von 1,8 bis 3,1 mit zahlenmittleren Molmassen von 200 bis 4000 g/mol, besonders bevorzugt sind Poly(tetrahydrofurane) mit einer Funktionalität von 1,9 bis 2,2 und zahlenmittleren Molmassen von 500 bis 2000 g/mol (insbesondere 600 bis 1400 g/mol). Als Anlagerungsprodukte sind Butyrolacton, ε-Caprolacton und/oder Methyl-ε-caprolacton, ε-Caprolacton ist besonders bevorzugt.

Solche Polyesterpolyole haben bevorzugt zahlenmittlere Molmassen von 400 bis 6000 g/Mol, besonders bevorzugt von 800 bis 3000 g/Mol. Ihre OH-Funktionalität beträgt bevorzugt 1.8 bis 3.5, besonders bevorzugt 1.9 bis 2.2.

Geeignete Polycarbonatpolyole sind in an sich bekannter Weise durch Umsetzung von organischen Carbonaten oder Phosgen mit Diolen oder Diol-Mischungen zugänglich.

Geeignete organische Carbonate sind Dimethyl-, Diethyl- und Diphenylcarbonat.

Geeignete Diole bzw. Mischungen umfassen die an sich im Rahmen der Polyestersegmente genannten mehrwertigen Alkoholen einer OH-Funktionalität ≥ 2, bevorzugt 1,4-Butandiol, 1,6-Hexandiol und/oder 3-Methylpentandiol, oder auch Polyesterpolyole können zu Polycarbonatpolyolen umgearbeitet werden.

Solche Polycarbonatpolyole haben bevorzugt zahlenmittlere Molmassen von 400 bis 4000 g/Mol, besonders bevorzugt von 500 bis 2000 g/Mol. Die OH-Funktionalität dieser Polyole beträgt bevorzugt 1.8 bis 3.2, besonders bevorzugt 1.9 bis 3.0.

Geeignete Polyetherpolyole sind gegebenenfalls blockweise aufgebaute Polyadditionsprodukte cyclischer Ether an OH- oder NH-funktionelle Startermoleküle.

Geeignete cyclische Ether sind beispielsweise Styroloxide, Ethylenoxid, Propylenoxid, Tetrahydrofuran, Butylenoxid, Epichlorhydrin, sowie ihre beliebigen Mischungen.

Als Starter können die an sich im Rahmen der Polyesterpolyole genannten mehrwertigen Alkohole einer OH-Funktionalität ≥ 2 sowie primäre oder sekundäre Amine und Aminoalkohole verwendet werden.

Bevorzugte Polyetherpolyole sind solche der vorgenannten Art ausschließlich basierend auf Propylenoxid oder statistische oder Block-Copolymere basierend auf Propylenoxid mit weiteren 1-Alkylenoxiden, wobei der 1-Alykenoxidanteil nicht höher als 80 Gew.-% ist. Besonders bevorzugt sind Propylenoxid-homopolymere sowie statistische oder Block-Copolymere, die Oxyethylen-, Oxypropylen- und/oder Oxybutyleneinheiten aufweisen, wobei der Anteil der Oxypropyleneinheiten bezogen auf die Gesamtmenge aller Oxyethylen-, Oxypropylen- und Oxybutyleneinheiten mindestens 20 Gew.-%, bevorzugt mindestens 45 Gew.-% ausmacht. Oxypropylen- und Oxybutylen- umfasst hierbei alle jeweiligen linearen und verzweigten C3- und C4-Isomere.

Solche Polyetherpolyole haben bevorzugt zahlenmittlere Molmassen von 250 bis 10000 g/Mol, besonders bevorzugt von 500 bis 8500 g/Mol und ganz besonders bevorzugt von 600 bis 4500 g/Mol. Die OH-Funktionalität beträgt bevorzugt 1.5 bis 4.0, besonders bevorzugt 1.8 bis 3.1 und ganz besonders bevorzugt 1.9 bis 2.2.

Als spezielle Polyetherpolyole werden bevorzugt solche eingesetzt, die aus einer isocyanatreaktiven Komponente umfassend hydroxyfunktionelle Multiblockcopolymere des Typs Y(Xi-H)n mit i = 1 bis 10 und n = 2 bis 8 und zahlenmittleren Molekulargewichten von größer 1500 g/Mol bestehen, wobei die Segmente Xi jeweils aus Oxyalkyleneinheiten der Formel (I) aufgebaut sind,

-CH2-CH(R)-O- Formel (1)

wobei R ein Wasserstoff-, Alkyl-, oder Arylrest, ist, der auch substituiert oder durch Heteroatome (wie Ethersauerstoffe) unterbrochen sein kann, Y der zugrundeliegende Starter ist und der Anteil der Segmente Xi bezogen auf die Gesamtmenge der Segmente Xi und Y wenigstens 50 Gew.-% ausmacht.

Die äußeren Blöcke $X_i$ machen dabei zumindest 50 Gew.-%, bevorzugt 66 Gew.-% der Gesamtmolmasse von $Y(X_i\text{-}H)_n$ aus und bestehen aus Monomereinheiten, die der Formel (1) gehorchen. Bevorzugt ist n in $Y(X_i\text{-}H)_n$ eine Zahl von 2 bis 6, besonders bevorzugt 2 oder 3 und ganz besonders bevorzugt gleich 2. Bevorzugt ist i in $Y(X_i\text{-}H)_n$ eine Zahl von 1 bis 6, besonders bevorzugt von 1 bis 3 und ganz besonders bevorzugt gleich 1.

In Formel (I) ist R bevorzugt ein Wasserstoff, eine Methyl-, Butyl-, Hexyl- oder Octylgruppe oder ein ethergruppenhaltiger Alkylrest. Bevorzugte ethergruppenhaltiger Alkylreste sind solche basierend auf Oxyalkyleneinheiten.

Die Multiblockcopolymere $Y(X_i\text{-}H)_n$ haben bevorzugt zahlenmittlere Molekulargewichte von mehr als 1200 g/Mol, besonders bevorzugt mehr als 1950 g/Mol, jedoch bevorzugt nicht mehr als 12000 g/Mol, besonders bevorzugt nicht mehr als 8000 g/Mol.

Die Blöcke $X_i$ können Homopolymere aus ausschließlich gleichen Oxyalkylen-Wiederholungseinheiten sein. Sie können auch statistisch aus verschiedenen Oxyalkyleneinheiten oder ihrerseits blockweise aus verschiedenen Oxyalkyleneinheiten aufgebaut sein.

Bevorzugte basieren die Segmente $X_i$ ausschließlich auf Propylenoxid oder statistischen oder blockweisen Mischungen von Propylenoxid mit weiteren 1-Alkylenoxiden, wobei der Anteil an weiteren 1-Alykenoxiden nicht höher als 80 Gew.-% ist.

Besonders bevorzugt sind als Segmente $X_i$ Propylenoxid-homopolymere sowie statistische oder Block-Copolymere, die Oxyethylen- und/oder Oxypropyleneinheiten, wobei der Anteil der Oxypropyleneinheiten bezogen auf die Gesamtmenge aller Oxyethylen- und Oxypropyleneinheiten mindestens 20 Gew.-%, bevorzugt mindestens 40 Gew.-% ausmacht.

Die Blöcke $X_i$ werden wie weiter unten beschrieben durch ringöffnende Polymerisation der vorstehend beschriebenen Alkylenoxide auf einen n-fach hydroxy- oder aminofunktionellen Starterblock $Y(H)_n$ aufaddiert.

Der innere Block Y, der zu kleiner 50 Gew.-%, bevorzugt aus kleiner 34 Gew.-% in $Y(X_i\text{-}H)_n$ enthalten ist, besteht aus di- und/oder höher hydroxyfunktionellen Polymerstrukturen auf Basis cyclischer Ether oder ist aufgebaut aus di- und/oder höher hydroxyfunktionellen Polycarbonat-, Polyester-, Poly(meth)acrylat-, Epoxydharz- und/oder Polyurethanstruktureinheiten oder entsprechenden Hybriden.

Geeignete Polyesterpolyole sind lineare Polyesterdiole oder verzweigte Polyesterpolyole, wie sie in bekannter Weise aus aliphatischen, cycloaliphatischen oder aromatischen Di- bzw. Polycarbonsäuren bzw. ihren Anhydriden wie z. B. Bernstein-, Glutar-, Adipin-, Pimelin-, Kork-, Azelain-, Sebacin-, Nonandicarbon-, Decandicarbon-, Terephthal-, Isophthal-, o-Phthal-, Tetrahydrophthal-, Hexahydrophthal- oder Trimellitsäure sowie Säureanhydride wie o-Phthal-, Trimellit- oder Bernsteinsäureanhydrid oder deren beliebiger Gemische mit mehrwertigen Alkoholen wie z. B. Ethandiol, Di-, Tri-, Tetraethylenglykol, 1,2-Propandiol, Di-, Tri-, Tetrapropylenglykol, 1,3-Propandiol, Butandiol-1,4, Butandiol-1,3, Butandiol-2,3, Pentandiol-1,5, Hexandiol-1,6, 2,2-Dimethyl-1,3-propandiol, 1,4-Dihydroxycyclohexan, 1,4-Dimethylolcyclohexan, Octandiol-1,8, Decandiol-1,10, Dodecandiol-1,12 oder deren Gemische gegebenenfalls unter Mitverwendung höherfunktioneller Polyole wie Trimethylolpropan oder Glycerin hergestellt werden können. Als mehrwertige Alkohole zur Herstellung der Polyesterpolyole kommen natürlich auch cycloaliphatische und/oder aromatische Di- und Polyhydroxylverbindungen in Frage. Anstelle der freien Polycarbonsäure können auch die entsprechenden Polycarbonsäureanhydride oder entsprechende Polycarbonsäureester von niedrigen Alkoholen oder deren Gemische zur Herstellung der Polyester verwendet werden.

Die Polyesterpolyole können auch auf natürlichen Rohstoffen wie Rizinusöl basieren. Ebenfalls möglich ist, dass die Polyesterpolyole auf Homo- oder Mischpolymerisaten von Lactonen basieren, wie sie bevorzugt durch Anlagerung von Lactonen bzw. Lactongemischen wie Butyrolacton, ε-Caprolacton und/oder Methyl-ε-caprolacton an hydroxyfunktionelle Verbindungen wie mehrwertige Alkohole einer OH-Funktionalität von bevorzugt 2, beispielsweise der vorstehend genannten Art, erhalten werden können.

Solche Polyesterpolyole haben bevorzugt zahlenmittlere Molmassen von 200 bis 2000 g/Mol, besonders bevorzugt von 400 bis 1400 g/Mol.

Geeignete Polycarbonatpolyole sind in an sich bekannter Weise durch Umsetzung von organischen Carbonaten oder Phosgen mit Diolen oder Diol-Mischungen zugänglich.

Geeignete organische Carbonate sind Dimethyl-, Diethyl- und Diphenylcarbonat.

Geeignete Diole bzw. Mischungen umfassen die an sich im Rahmen der Polyesterpolyole genannten mehrwertigen Alkohole einer OH-Funktionalität von 2, bevorzugt 1,4-Butandiol, 1,6-Hexandiol und/oder 3-Methylpentandiol. Polyesterpolyole können auch zu Polycarbonatpolyolen umgearbeitet werden. Besonders bevorzugt werden bei der Umsetzung der genannten Alkohole zu Polycarbonatpolyolen Dimethyl- oder Diethylcarbonat eingesetzt.

Solche Polycarbonatpolyole haben bevorzugt zahlenmittlere Molmassen von 400 bis 2000 g/Mol, besonders bevorzugt von 500 bis 1400 g/Mol und ganz besonders bevorzugt von 650 bis 1000 g/Mol.

Geeignete Polyetherpolyole sind gegebenenfalls blockweise aufgebaute Polyadditionsprodukte cyclischer

Ether an OH- oder NH-funktionelle Startermoleküle. Als Polyetherpolyole seien z. B. die Polyadditionsprodukte der Styroloxide, des Ethylenoxid, Propylenoxid, Tetrahydrofuran, Butylenoxid, Epichlorhydrins, sowie ihre Mischadditions- und Pfropfprodukte, sowie die durch Kondensation von mehrwertigen Alkoholen oder Mischungen derselben und die durch Alkoxylierung von mehrwertigen Alkoholen, Aminen und Aminoalkoholen gewonnenen Polyetherpolyole.

Geeignete Polymere cyclischer Ether sind insbesondere Polymere des Tetrahydrofuran.

Als Starter können die an sich im Rahmen der Polyesterpolyole genannten mehrwertigen Alkohole sowie primäre oder sekundäre Amine und Aminoalkohole einer OH- oder NH-Funktionalität von 2 bis 8, bevorzugt 2 bis 6, besonders bevorzugt 2 bis 3, ganz besonders bevorzugt gleich 2 verwendet werden.

Solche Polyetherpolyole haben bevorzugt zahlenmittlere Molmassen von 200 bis 2000 g/Mol, besonders bevorzugt von 400 bis 1400 g/Mol und ganz besonders bevorzugt von 650 bis 1000 g/Mol.

Als für Starter verwendete Polyetherpolyole werden bevorzugt die Polymere des Tetrahydrofuran eingesetzt.

Selbstverständlich können auch Mischungen der oben beschriebenen Komponenten für den inneren Block Y eingesetzt werden.

Bevorzugte Komponenten für den inneren Block Y sind Polymere des Tetrahydrofuran sowie aliphatische Polycarbonatpolyole und Polyesterpolyole sowie Polymere des ε-Caprolacton mit zahlenmittleren Molmassen kleiner 3100 g/Mol.

Besonders bevorzugte Komponenten für den inneren Block Y sind difunktionelle Polymere des Tetrahydrofuran sowie difunktionelle aliphatische Polycarbonatpolyole und Polyesterpolyole sowie Polymere des ε-Caprolacton mit zahlenmittleren Molmassen kleiner 3100 g/Mol.

Ganz besonders bevorzugt basiert das Startersegment Y auf difunktionellen, aliphatischen Polycarbonatpolyolen, Poly(ε-Caprolacton) oder Polymeren des Tetrahydrofurans mit zahlenmittleren Molmassen größer 500 g/Mol und kleiner 2100 g/Mol.

Bevorzugt eingesetzte Blockcopolymere der Struktur $Y(X_i\text{-}H)_n$ bestehen zu mehr als 50 Gewichtsprozent aus den oben als erfindungsgemäß beschriebenen Blöcken $X_i$ und haben eine zahlenmittlere Gesamtmolmasse von größer 1200 g/Mol.

Besonders bevorzugte Blockcopolyole bestehen zu weniger als 50 Gewichtsprozent aus aliphatischem Polyester, aliphatischem Polycarbonatpolyol oder Poly-THF und zu mehr als 50 Gewichtsprozent aus den oben als erfindungsgemäß beschriebenen Blöcken $X_i$ und haben eine zahlenmittlere Molmasse von größer 1200 g/Mol. Besonders bevorzugte Blockcopolymere bestehen bestehen zu weniger als 50 Gewichtsprozent aliphatischem Polycarbonatpolyol, Poly(ε-Caprolacton) oder Poly-THF und zu mehr als 50 Gewichtsprozent aus den oben als erfindungsgemäß beschriebenen Blöcken $X_i$ und haben eine zahlenmittlere Molmasse von größer 1200 g/Mol.

Ganz besonders bevorzugte Blockcopolymere bestehen zu weniger als 34 Gewichtsprozent aus aliphatischem Polycarbonatpolyol, Poly(ε-Caprolacton) oder Poly-THF und zu mehr als 66 Gewichtsprozent aus den oben als erfindungsgemäß beschriebenen Blöcken $X_i$ und haben eine zahlenmittlere Molmasse von größer 1950 g/Mol und weniger als 9000 g/Mol.

Die beschriebenen Blockcopolyole werden durch Alkylenoxidadditionsverfahren hergestellt. Von großtechnischer Bedeutung ist zum einen die basisch katalysierte Anlagerung von Alkylenoxiden an Starterverbindungen mit Zerewitinoff-aktiven Wasserstoffatomen $Y(H)_n$, zum anderen die gewinnt die Verwendung von Doppelmetallcyanidverbindungen ("DMC-Katalysatoren") für die Durchführung dieser Reaktion zunehmend an Bedeutung. An N, O oder S gebundener Wasserstoff wird als Zerewitinoff-aktiver Wasserstoff (manchmal auch nur als "aktiven Wasserstoff') bezeichnet, wenn er nach einem von Zerewitinoff aufgefundenen Verfahren durch Umsetzung mit Methylmagnesiumjodid Methan liefert. Typische Beispiele für Verbindungen mit Zerewitinoffaktivem Wasserstoff sind Verbindungen, die Carboxyl-, Hydroxyl-, Amino-, Imino- oder Thiol-Gruppen als funktionelle Gruppen enthalten. Die basisch katalysierte Anlagerung von Alkylenoxiden wie beispielsweise Ethylenoxid oder Propylenoxid an Starterverbindungen mit Zerewitinoff-aktiven Wasserstoffatomen erfolgt in Gegenwart von Alkalimetallhydroxiden, es können aber auch Alkalimetallhydride, Alkalimetallcarboxylate oder Erdalkalihydroxide verwendet werden. Nach erfolgter Anlagerung der Alkylenoxide müssen die polymerisationsaktiven Zentren an den Polyetherketten deaktiviert werden, beispielsweise durch Neutralisation mit verdünnten Mineralsäuren wie Schwefelsäure oder Phosphorsäure und Abtrennung der entstehenden Salze. Im erfindungsgemäßen Verfahren werden bevorzugt DMC-Katalysatoren verwendet. Besonders bevorzugt eingesetzt werden hochaktive DMC-Katalysatoren, die z.B. beschrieben sind in US-A 5 470 813, EP-A 700 949, EP-A 743 093, EP-A 761 708, WO 97/40086, WO 98/16310 und WO 00/47649. Ein typisches Beispiel sind die in EP-A 700 949 beschriebenen hochaktiven DMC-Katalysatoren, die neben einer Doppelmetallcyanid-Verbindung (z.B. Zinkhexacyanocobaltat(III)) und einem organischen Komplexliganden (z.B. tert.-Butanol) noch einen Polyether mit einem zahlenmittlerem Molekulargewicht größer als 500 g/Mol enthalten. Diese Katalysatoren können aufgrund ihrer hohen Aktivität in solch kleinen Mengen eingesetzt werden, dass eine weitere Aufarbeitung der Polyetherpolyole nicht erforderlich ist. Das Verfahren ist unten ausführlicher beschrieben. Als "Starterpolyol" wird dabei stets die zu weniger als 50 Gewichtsprozent im Blockcopolymer enthaltene OH-funktionalisierte Vorstufe Y eingesetzt, auf die Alkylenoxid aufpolymerisiert witrd, so dass am Ende ein Multiblockcopolymer erhalten wird. Als Alkylenoxide kommen bevorzugt Ethylenoxid, Propylenoxid, Butylenoxid sowie

deren Mischungen zum Einsatz. Der Aufbau der Polyetherketten durch Alkoxylierung kann z.B. nur mit einem monomeren Epoxid durchgeführt werden oder auch statistisch oder blockweise mit mehreren unterschiedlichen monomeren Epoxiden erfolgen.

Bevorzugte Kombinationen aus Komponente a) und b) bei der Herstellung der Matrixpolymere sind:

A) Additionsprodukte von Butyrolacton, ε-Caprolacton und/oder Methyl-ε-caprolacton an Polyetherpolyolen einer Funktionalität von 1,8 bis 3,1 mit zahlenmittleren Molmassen von 200 bis 4000 g/mol in Verbindung mit Isocyanuraten, Uretdionen, Iminooxadiazindionen und/oder anderen Oligomeren basierend auf HDI. Besonders bevorzugt Additionsprodukte von ε-Caprolacton an Poly(tetrahydrofurane) mit einer Funktionalität von 1,9 bis 2,2 und zahlenmittleren Molmassen von 500 bis 2000 g/mol (insbesondere 600 bis 1400 g/mol), deren zahlenmittlere Gesamtmolmasse von 800 bis 4500 g/Mol, insbesondere von 1000 bis 3000 g/Mol liegt in Verbindung mit Oligomeren, Isocyanuraten und/oder Iminooxadiazindionen basierend auf HDI.

B) Polyetherpolyole mit zahlenmittlere Molmassen von 500 bis 8500 g/Mol und OH-Funktionalitäten von 1,8 bis 3,2, ausschließlich basierend auf Propylenoxid oder statistische oder Block-Copolyole basierend auf Propylenoxid und Ethylenoxid, wobei der Ethylenoxidanteil nicht höher als 60 Gew.-% ist in Verbindung mit Urethanen, Allophanaten oder Biureten aus aliphatischen Isocyanat-funktionellen Verbindungen und oligomeren oder polymeren Isocyanat-reaktiven Verbindungen mit zahlenmittleren Molmassen von 200 bis 6000 g/Mol. Besonders bevorzugt sind Propylenoxid-homopolymere mit zahlenmittlere Molmassen von 1800 bis 4500 g/Mol und OH-Funktionalitäten von 1,9 bis 2,2 in Verbindung mit Allophanaten aus HDI oder TMDI und difunktionellen Polyetherpolyolen (insbesondere Polypropylenglykolen) mit zahlenmittleren Molmassen von 200 bis 2100 g/Mol.

C) Polyetherblock- oder -multiblockcopolymere der Formel (I), wobei Y ein rein aliphatisches Polycarbonatpolyol oder ein Polymer des Tetrahydrofurans mit jeweils einer OH-Funktionalität von 1,8 bis 3,1 und einer zahlenmittlere Molmassen von 400 bis 2000 g/Mol ist, n = 2, i = 1 oder 2 und R = Methyl oder H ist, mit einer gesamten zahlenmittleren Molmasse von 1950 bis 9000 g/Mol, bevorzugt von 1950 bis 6000 g/Mol, in Verbindung mit Urethanen, Allophanaten oder Biureten aus aliphatischen Isocyanat-funktionellen Verbindungen und oligomeren oder polymeren Isocyanat-reaktiven Verbindungen mit zahlenmittleren Molmassen von 200 bis 6000 g/Mol oder in Verbindung mit Isocyanuraten, Uretdionen, Iminooxadiazindionen und/oder anderen Oligomeren basierend auf HDI. Besonders bevorzugt sind Polyetherblock- oder -multiblockcopolymere der Formel (I), wobei Y ein rein aliphatisches Polycarbonatpolyol auf Basis 1,4-Butandiol und/oder 1,6-Hexandiol mit Dimethyl- oder Diethylcarbonat oder ein Polymer des Tetrahydrofurans mit einer OH-Funktionalität von 1,8 bis 2,2 und einer zahlenmittlere Molmassen von 600 bis 1400 g/Mol (insbesondere bis 1000 g/Mol) ist, n = 2, i = 1 oder 2 und R = Methyl oder H ist, wobei der Anteil der Ethylenoxideinheiten an der Gesamtmasse von $X_i$ nicht höher als 60 Gew.-% ist, in Verbindung mit Allophanaten aus HDI oder TMDI und difunktionellen Polyetherpolyolen (insbesondere Polypropylenglykolen) mit zahlenmittleren Molmassen von 200 bis 2100 g/Mol, in Verbindung mit Biureten mit zahlenmittleren Molmassen von 200 bis 1400 g/Mol (insbesondere auch im Gemisch mit anderen Oligomeren difunktioneller aliphatischer Isocyanate) basierend auf aliphatischer Diaminen oder Polyaminen und aliphatischen Diisocyanaten, insbesondere HDI und TMDI, in Verbindung mit Urethanen aus HDI oder TMDI auf Basis von Additionsprodukten von Butyrolacton, ε-Caprolacton und/oder Methyl-ε-caprolacton (insbesondere ε-Caprolacton) an 2 bis 20 Kohlenstoffatome enthaltende aliphatische, araliphatische oder cycloaliphatische di-, tri- oder polyfunktionelle Alkohole (insbesondere an difunktionelle aliphatische Alkohole mit 3 bis 12 Kohlenstoffatomen) mit zahlenmittleren Molmassen von 200 bis 3000 g/Mol, insbesondere bevorzugt von 1000 bis 2000 g/Mol (insbesondere im Gemisch mit anderen Oligomeren difunktioneller aliphatischer Isocyanate) oder in Verbindung mit Isocyanuraten, Iminooxadiazindionen und/oder anderen Oligomeren basierend auf HDI.

Vorzugsweise kann das monofunktionelle Schreibmonomer (Komponente B)) die allgemeine Formel (II)

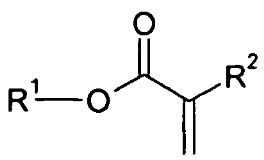

(II)

haben, in der $R^1$, $R^2$ Wasserstoff und / oder unabhängig voneinander lineare, verzweigte, cyclische oder heterocyclische unsubstituierte oder gegebenenfalls auch mit Heteroatomen substituierte organische Reste sind. Besonders bevorzugt

ist, wenn das monofunktionelle Schreibmonomer eine Glastemperatur $T_G$ < 15°C aufweist.

Bei dem multifunktionellen Schreibmonomer (Komponente B)) kann es sich insbesondere um Verbindungen handeln, die die allgemeine Formel (III)

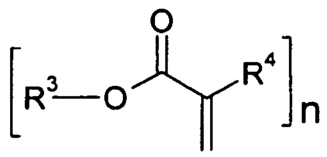

(III)

haben, in der n≥2 und n≤4 ist und $R^3$, $R^4$ Wasserstoff und / oder unabhängig voneinander lineare, verzweigte, cyclische oder heterocyclische unsubstituierte oder gegebenenfalls auch mit Heteroatomen substituierte organische Reste sind. Dabei ist weiter bevorzugt, wenn das multifunktionelle Schreibmonomer einen Brechungsindex von $n_D^{20}$ > 1.50 aufweist.

Als erfindungswesentliche Schreibcomonomere können Mischungen von Verbindungen wie α,β-ungesättigte Carbonsäurederivate auf Acrylatbasis wie Acrylate, Methacrylate, Acrylamide, (Meth)acrylnitril, (Meth)acrylamid, Methacrylsäure, Acrylsäure eingesetzt werden. Bevorzugt sind Acrylate und Methacrylate.

Als Acrylate bzw. Methacrylate werden allgemein Ester der Acrylsäure bzw. Methacrylsäure bezeichnet. Beispiele verwendbarer Acrylate und Methacrylate sind Methylacrylat, Methylmethacrylat, Ethylacrylat, Ethylmethacrylat, Ethoxyethylacrylat, Ethoxyethylmethacrylat, n-Butylacrylat, n-Butylmethacrylat, tert.-Butylacrylat, tert.-Butylmethacrylat, Hexylacrylat, Hexylmethacrylat, 2-Ethylhexylacrylat, 2-Ethylhexylmethacrylat, Butoxyethylacrylat, Butoxyethylmethacrylat, Laurylacrylat, Laurylmethacrylat, Isobornylacrylat, Isobornylmethacrylat, Phenylacrylat, Phenylmethacrylat, p-Chlorphenylacrylat, p-Chlorphenylmethacrylat, p-Bromphenylacrylat, p-Bromphenyl-methacrylat, 2,4,6-Trichlorphenylacrylat, 2,4,6-Trichlorphenylmethacrylat, 2,4,6-Tribromphenyl-acrylat, 2,4,6-Tribromphenylmethacrylat, Pentachlorphenylacrylat, Pentachlorphenylmethacrylat, Pentabromphenylacrylat, Pentabromphenylmethacrylat, Pentabrombenrylacrylat, Pentabrombenzylmethacrylat, Phenoxyethylacrylat, Phenoxyethylmethacrylat, Phenoxyethoxyethylacrylat, Phenoxyethoxyethylmethacrylat, 2-Naphthylacrylat, 2-Naphthylmethacrylat, 1,4-Bis-(2-thionaphthyl)-2-butylacrylat, 1,4-Bis-(2-thionaphthyl)-2-butylmethacrylat, Propan-2,2-diylbis[(2,6-dibrom-4,1-phenylen)oxy(2-{[3,3,3-tris(4-chlorphenyl)-propanoyl]-oxy}propan-3,1-diyl)oxyethan-2,1-diyl]-diacrylat, Bisphenol A Diacrylat, Bisphenol A Dimethacrylat, Tetrabromobisphenol A Diacrylat, Tetrabromobisphenol A Dimethacrylat sowie deren ethoxylierte Analogverbindungen, N-Carbazolylacrylate um nur eine Auswahl zu nennen.

Bevorzugt werden dabei Acrylate und Methacrylate mit einem Brechungsindex $n_D^{20}$ von größer 1,450 eingesetzt. Besonders bevorzugt werden Acrylate eingesetzt, die mindestens eine aromatische Struktureinheit enthalten und einen Brechungsindex $n_D^{20}$ von größer 1,500 haben. Als besonders geeignete Beispiele hierfür sind Acrylate und Methacrylate auf Basis von Bisphenol A oder dessen Derivate zu nennen sowie solche Acrylate und Methacrylate, die eine Thioarylgruppe enthalten.

Bevorzugt können auch Urethanacrylate als Schreibcomonomere verwendet werden. Unter Urethanacrylaten versteht man Verbindungen mit mindestens einer Acrylsäureestergruppe die zusätzlich über mindestens eine Urethanbindung verfügen. Es ist bekannt, dass solche Verbindungen durch Umsetzung eines Hydroxy-funktionellen Acrylsäureesters mit einer Isocyanat-funktionellen Verbindung erhalten werden können.

Beispiele hierfür verwendbarer Isocyanate sind aromatische, araliphatische, aliphatische und cycloaliphatische Di-, Tri- oder Polyisocyanate. Es können auch Mischungen solcher Di-, Tri- oder Polyisocyanate eingesetzt werden. Beispiele geeigneter Di-, Tri- oder Polyisocyanate sind Butylendiisocyanat, Hexamethylendiisocyanat (HDI), Isophorondiisocyanat (IPDI), 1,8-Diisocyanato-4-(isocyanatomethyl)oktan, 2,2,4- und/oder 2,4,4-Trimethylhexamethylendiisocyanat, die isomeren Bis(4,4'-isocyanatocyclohexyl)methane und deren Mischungen beliebigen Isomerengehalts, Isocyanatomethyl-1,8-octandiisocyanat, 1,4-Cyclohexylendiisocyanat, die isomeren Cyclohexandimethylendiisocyanate, 1,4-Phenylendiisocyanat, 2,4- und/oder 2,6-Toluylendiisocyanat, 1,5-Naphthylendiisocyanat, 2,4'- oder 4,4'-Diphenylmethandiisocyanat, 1,5-Naphthylendiisocyanat, Triphenylmethan-4,4',4"-triisocyanat und Tris(p-isocyanatophenyl)thiophosphat oder deren Derivate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur und Mischungen derselben. Bevorzugt sind dabei aromatische oder araliphatische Di-, Tri- oder Polyisocyanate.

Als hydroxyfunktionelle Acrylate oder Methacrylate für die Herstellung von Urethanacrylaten kommen beispielsweise in Betracht Verbindungen wie 2-Hydroxyethyl(meth)acrylat, Polyethylenoxid-mono(meth)acrylate, Polypropylenoxidmono(meth)acrylate, Polyalkylenoxidmono(meth)acrylate, Poly(ε-caprolacton)mono(meth)acrylate, wie z.B. Tone® M100 (Dow, Schwalbach, DE), 2-Hydroxypropyl(meth)acrylat, 4-Hydroxybutyl(meth)acrylat, 3-Hydroxy-2,2-dimethylpropyl-(meth)acrylat, Hydroxypropyl(meth)acrylat, Acrylsäure-(2-hydroxy-3-phenoxypropylester), die hydroxyfunktionellen Mono-, Di- oder Tetraacrylate mehrwertiger Alkohole wie Trimethylolpropan, Glycerin, Pentaerythrit, Dipentaerythrit, ethoxyliertes, propoxyliertes oder alkoxyliertes Trimethylolpropan, Glycerin, Pentaerythrit, Dipentaerythrit oder deren technische Gemische. Bevorzugt sind 2-Hydroxyethylacrylat, Hydroxypropylacrylat, 4-Hydroxybutylacrylat und Poly(ε-caprolacton)mono(meth)acrylate. Darüberhinaus sind als isocyanat-reaktive oligomere oder polymere ungesättigte Acrylat- und/oder Methacrylatgruppen enthaltende Verbindungen alleine oder in Kombination mit den vorgenannten monomeren Verbindungen geeignet. Ebenfalls verwendet werden können die an sich bekannten hydroxylgruppenhaltigen Epoxy(meth)acrylate mit OH-Gehalten von 20 bis 300 mg KOH/g oder hydroxylgruppenhaltige Polyurethan(meth)acrylate mit OH-Gehalten von 20 bis 300 mg KOH/g oder acrylierte Polyacrylate mit OH-Gehalten von 20 bis 300 mg KOH/g sowie deren Mischungen untereinander und Mischungen mit hydroxylgruppenhaltigen ungesättigten Polyestern sowie Mischungen mit Polyester(meth)acrylaten oder Mischungen hydroxylgruppenhaltiger ungesättigter Polyester mit Polyester(meth)acrylaten. Bevorzugt sind hydroxylgruppenhaltige Epoxyacrylate mit definierter Hydroxyfunktionalität. Hydroxylguppenhaltige Epoxy(meth)acrylate basieren insbesondere auf Umsetzungsprodukten von Acrylsäure und/oder Methacrylsäure mit Epoxiden (Glycidylverbindungen) von monomeren, oligomeren oder polymeren Bisphenol-A, Bisphenol-F, Hexandiol und/oder Butandiol oder deren ethoxylierten und/oder propoxylierten Derivaten. Bevorzugt sind weiterhin Epoxyacrylate mit definierter Funktionalität wie sie aus der bekannten Umsetzung von Acrylsäure und/oder Methacrylsäure und Glycidyl(meth)acrylat erhalten werden können.

Bevorzugt werden Mischungen von (Meth-)Acrylaten und/oder Urethan(meth-)acrylaten verwendet, besonders bevorzugt von (Meth-)Acrylaten und/oder Urethan(meth-)acrylaten, die mindestens eine aromatische Struktureinheit aufweisen.

Besonders bevorzugte als Schreibcomonomere zu verwendende Verbindungen sind Mischungen von Urethanacrylaten und Urethanmethacrylaten auf Basis aromatischer Isocyanate und 2-Hydroxyethylacrylat, Hydroxypropylacrylat, 4-Hydroxybutylacrylat, Polyethylenoxid-mono-(meth)acrylat, Polypropylenoxidmono(meth)acrylat, Polyalkylenoxidmono(meth)acrylat und Poly(ε-caprolacton)mono(meth)-acrylate.

In einer ganz besonders bevorzugten Ausführungsform werden als Schreibcomonomere die Mischungen der Additionsprodukte aromatischer Triisocyanate (ganz besonders bevorzugt Tris-(4-phenylisocyanato)-thiophosphat oder Trimere aromatischer Diisocyanate wie Toluylendiisocyanat) mit Hydroxyethylacrylat, Hydroxypropylacrylat, 4-Hydroxybutylacrylat zusammen mit den Additionsprodukten von 3-Thiomethyl-phenylisocyanat mit Hydroxyethylacrylat, Hydroxypropylacrylat, 4-Hydroxybutylacrylat eingesetzt (wie in den Anmeldungen WO 2008/125229 A1 und in der nicht vorveröffentlichten Anmeldung EP 09009651.2 beschrieben)

Weiterhin ist die Verwendung von Glycidyletheracrylaturethanen als Schreibmonomere bevorzugt. Diese gehorchen der allgemeinen Formel (IVa) oder (IVb) oder Mischungen aus (IVa) und (IVb)

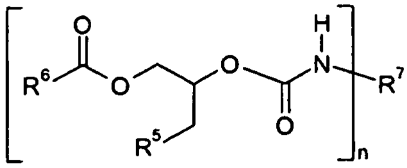

Formel (IVa)

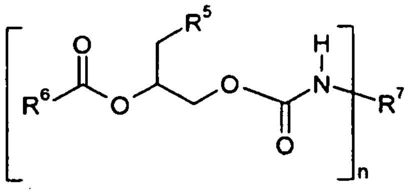

Formel (IVb)

wobei

n eine natürliche Zahl von 2 bis 6 ist

$R^5$ ein ein- oder mehrkerniger Aromatengruppen haltiger organischer Rest mit 4 bis 36 Kohlenstoffatomen ist,

$R^6$ ein olefinisch ungesättigter Rest mit 3 bis 30 Kohlenstoffatomen ist und

$R^7$ ein von einem aliphatischen oder aromatischen Di- oder Polyisocyanat abgeleiteter organischer Rest mit 2 bis 30

Kohlenstoffatomen ist.

Die ungesättigten Glycidyletheracrylaturethane der Formel IVa bzw. IVb können in einer 2-Stufen Synthese hergestellt werden. In der ersten Umsetzung wird eine ungesättigte Carbonäure mit einem Epoxid zur Reaktion gebracht, wobei ein Gemisch zweier Alkohole gebildet wird. In einem zweiten Reaktionsschritt wird dieses Alkoholgemisch mittels eines Di- oder Polyisocyanats $R^7(NCO)_n$ der Funktionalität n zum Glycidyletheracrylaturethan urethanisiert (wie in der nicht vorveröffentlichten Anmeldung EP 09002180.9 beschrieben). Bevorzugt werden dabei Methacrylsäure und Acrylsäure oder deren Derivate als Epoxide finden bevorzugt aromatische Epoxide wie Phenyl-, Dibromophenyl-, Naphthyl- oder Biphenylglycidether Anwendung und als Isocyanatkomponente verwendet man bevorzugt Toluolyldiisocyanat (TDI), Hexamethylendiisocyanat (HDI) oder Triisocyanatononan (TIN).

In einer ganz besonders bevorzugten Ausführungsform werden die Kombinationen aus (Acrylsäure, Biphenylglycidether und HDI), (Acrylsäure, Phenylglycidether und TDI) sowie (Acrylsäure, Biphenyglycidether und HDI) verwendet.

Weiterhin sind auch spezielle Methacrylate verwendbar der allgemeinen Formeln Va und Vb

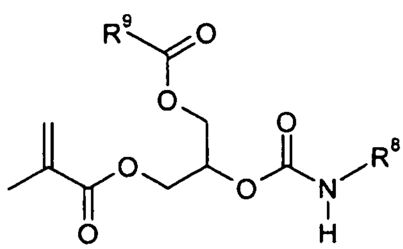 (Va) 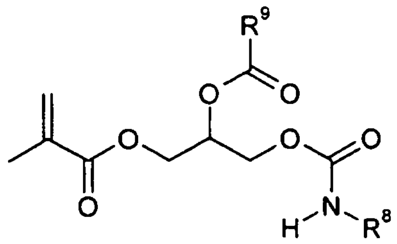 (Vb)

wobei $R^8$ und $R^9$ unabhängig voneinander substituierte Phenyl-, substituierte und / oder unsubstituierte Naphtylreste sind. Vorzugsweise können $R^8$ und / oder $R^9$ 6-24 C-Atome, 0-5 S-Atome und 0-5 Halogenatome umfassen.

Gemäß einer bevorzugten Ausführungsform können $R^8$ und /oder $R^9$ mit Thioethergruppen, Phenylgruppen und / oder Halogenatome substituiert sein.

Ganz besonders bevorzugt ist, wenn $R^8$ und / oder $R^9$ Napthyl, 3-Methylthiophenyl, 2-, 3-, 4-Biphenyl, 2-Bromphenyl sind.

Die Herstellung der Methacrylate erfolgt in einer 2-Stufen Synthese. In der ersten Umsetzung wird eine Säure $R^9$-COOH mit Glycidylmethacrylat zur Reaktion gebracht, wobei ein Gemisch zweier Alkohole gebildet wird, einem zweiten Reaktionsschritt wird das Alkoholgemisch mit einem Monoisocyanat $R^8$-NCO zu dem Methacrylatgemisch urethanisiert.

In eine ganz besonders bevorzugten Ausführungsform werden die Kombinationen aus (Glycidylmethacrylat, Naphthoesäure und 3-Thiomethyl-phenylisocyanat) verwendet.

Als Komponente C) werden ein oder mehrere Photoinitiatoren eingesetzt. Dies sind üblicherweise durch aktinische Strahlung aktivierbare Initiatoren, die eine Polymerisation der entsprechenden polymerisierbaren Gruppen auslösen. Photoinitiatoren sind an sich bekannte, kommerziell vertriebene Verbindungen, wobei zwischen unimolekularen (Typ I) und bimolekularen (Typ II) Initiatoren unterschieden wird. Desweiteren werden diese Initiatoren je nach chemischer Natur für die radikalische, die anionische (oder), die kationische (oder gemischte) Formen der vorgenannten Polymerisationen eingesetzt.

(Typ I)-Systeme für die radikalische Photopolymerisation sind z.B. aromatische Ketonverbindungen, z.B. Benzophenone in Kombination mit tertiären Aminen, Alkylbenzophenone, 4,4'-Bis(dimethylamino)benzophenon (Michlers Keton), Anthron und halogenierte Benzophenone oder Mischungen der genannten Typen. Weiter geeignet sind (Typ II)-Initiatoren wie Benzoin und seine Derivate, Benzilketale, Acylphosphinoxide z.B. 2,4,6-Trimethylbenzoyl-diphenylphosphinoxid, Bisacylophosphinoxide, Phenylglyoxylsäureester, Campherchinon, alpha-Aminoalkylphenone, alpha-,alpha-Dialkoxyacetophenone, 1-[4-(Phenylthio)phenyl]octan-1,2-dion-2-(O-benzoyloxim), unterschiedlich substituierte Hexarylbisimidazole (HABI) mit geeigneten Coinitiatoren wie z.B. Mercaptobenzoxazol sowie alpha-Hydroxyalkylphenone. Auch die in EP-A 0223587 beschriebenen Photoinitiatorsysteme bestehend aus einer Mischung aus einem Ammoniumarylborat und einem oder mehreren Farbstoffen können als Photoinitiator eingesetzt werden. Als Ammoniumarylborat eignen sich beispielsweise Tetrabutylammonium Triphenylhexylborat, Tetrabutylammonium Triphenylbutylborat, Tetrabutylammonium Trinapthylbutylborat, Tetramethylammonium Triphenylbenzylborat, Tetra(n-hexyl)ammonium (sec-Butyl)triphenylborat, 1-Methyl-3-octylimidazolium Dipentyldiphenylborat, Tetrabutylammonium Tris-(4-tert.-butyl)-phenylbutylborat, Tetrabutylammonium Tris-(3-fluorphenyl)-hexylborat und Tetrabutylammonium Tris-(3-Chlor-4-methylphenyl)-hexylborat. Als Farbstoffe eignen sich beispielsweise Neu-Methylenblau, Thionin, Basic Yellow,

Pinacynol Chlorid, Rhodamin 6G, Gallocyanin, Ethylviolett, Victoria Blue R, Celestine Blue, Chinaldinrot, Kristallviolett, Brilliant Grün, Astrazon Orange G, Darrow Red, Pyronin Y, Basic Red 29, Pyrillium I, Safranin O, Cyanin und Methylenblau, Azur A (Cunningham et al., RadTech'98 North America UV/EB Conference Proceedings, Chicago, Apr. 19-22, 1998).

Die für die anionische Polymerisation verwendeten Photoinitiatoren sind in der Regel (Typ I)-Systeme und leiten sich von Übergangsmetall-Komplexen der ersten Reihe ab. Hier sind ChromSalze, wie z.B. trans-$Cr(NH_3)_2(NCS)_4$-(Kutal et al, Macromolecules 1991, 24, 6872) oder Ferrocenyl-Verbindungen (Yamaguchi et al. Macromolecules 2000, 33, 1152). Eine weitere Möglichkeit der anionischen Polymerisation besteht in der Verwendung von Farbstoffen, wie Kristallviolett Leukonitril oder Malchit Grün Leukonitril, die durch photolytischen Zerfall Cyanoacrylate polymerisieren können (Neckers et al. Macromolecules 2000, 33, 7761). Allerdings wird dabei das Chromophor in das Polymer eingebaut, so dass die resultierenden Polymere durchgefärbt sind.

Die für die kationische Polymerisation verwendeten Photoinitiatoren bestehen im wesentlichen aus drei Klassen: Aryldiazonium-Salze, Onium-Salze (hier speziell: Iodonium-, Sulfonium- und Selenonium-Salze) sowie Organometall-Verbindungen. Phenyldiazonium-Salze können unter Bestrahlung sowohl in Gegenwart als auch in Abwesenheit eines Wasserstoff-Donors ein Kation erzeugten, dass die Polymerisation initiiert. Die Effizienz des Gesamtsystems wird durch die Natur des verwendeten Gegenions zur Diazonium-Verbindung bestimmt. Bevorzugt sind hier die wenig reaktiven aber recht teuren SbF6-, AsF6- oder PF6-. Für den Einsatz in Beschichtung dünner Filme sind diese Verbindungen i.d.R wenig geeignet, da die den nach der Belichtung freigesetzten Stickstoff die Oberflächegüte herabgesetzt wird (pinholes) (Li et al., Polymeric Materials Science and Engineering, 2001, 84, 139). Sehr weit verbreitet und auch in vielerlei Form kommerziell erhältlich sind Onium-Salze, speziell Sulfonium- und Iodonium-Saize. Die Photochemie dieser Verbindungen ist nachhaltig untersucht worden. Die Iodonium-Salze zerfallen nach der Anregung zunächst homolytisch und erzeugen somit ein Radikal und ein Radikalanion, welches sich durch H-Abstraktion stabilisiert und ein Proton freisetzt und dann die kationische Polymerisation startet (Dektar et al. J. Org. Chem. 1990, 55, 639; J. Org. Chem., 1991, 56. 1838). Dieser Mechanimus ermöglicht den Einsatz von Iodonium-Salzen ebenfalls für die radikalische Photopolymerisation. Hierbei kommt erneut der Wahl des Gegenions eine große Bedeutung zu, bevorzugt werden ebenfalls $SbF_6^-$, $AsF_6^-$ oder $PF_6^-$. Ansonsten in dieser Strukturklasse die Wahl der Substitution des Aromaten recht frei und im wesentlichen durch die Verfügbarkeit geeigneter Startbausteine für die Synthese bestimmt. Bei den Sulfonium-Salzen handelt es sich um Verbindungen, die in nach Norrish(II) zerfallen (Crivello et al., Macromolecules, 2000, 33, 825). Auch bei den Sulfonium-Salzen kommt der Wahl des Gegenions eine kritische Bedeutung zu, die sich im Wesentlichen in der Härtungsgeschwindigkeit der Polymere äußert. Die besten Ergebnisse werden i.d.R. mit $SbF_6$-Salzen erzielt. Da die Eigenabsorption von Iodonium- und Sulfonium-Salze bei <300nm liegt, müssen diese Verbindungen für die Photopolymerisation mit nahem UV oder kurzwelligem sichtbarem Licht entsprechend sensibilisiert werden. Dies gelingt durch die Verwendung von höher absorbierenden Aromaten wie z.B. Anthracen und Derivaten (Gu et al., Am. Chem. Soc. Polymer Preprints, 2000, 41 (2), 1266) oder Phenothiazin bzw. dessen Derivate (Hua et al, Macromolecules 2001, 34, 2488-2494).

Es kann vorteilhaft sein auch Gemische dieser Verbindungen einzusetzen. Je nach zur Härtung verwendeter Strahlungsquelle muss Typ und Konzentration an Photoinitiator in dem Fachmann bekannter Weise angepasst werden. Näheres ist zum Beispiel in P. K. T. Oldring (Ed.), Chemistry & Technology of UV & EB Formulations For Coatings, Inks & Paints, Vol. 3, 1991, SITA Technology, London, S. 61 - 328 beschrieben.

Bevorzugte Photoinitiatoren sind Mischungen aus Tetrabutylammonium Triphenylhexylborat, Tetrabutylammonium Triphenylbutylborat, Tetrabutylammonium Trinapthylbutylborat, Tetrabutylammonium Tris-(4-tert.-butyl)-phenylbutylborat, Tetrabutylammonium Tris-(3-fluorphenyl)-hexylborat und Tetrabutylammonium Tris-(3-Chlor-4-methylphenyl)-hexylborat mit Farbstoffen wie beispielsweise Astrazon Orange G, Methylenblau, Neu Methylenblau, Azur A, Pyrillium 1, Safranin O, Cyanin, Gallocyanin, Brilliant Grün, Kristallviolett, Ethylviolett und Thionin.

Das verwendete Photoinitiatorsystem kann vorzugsweise einen anionischen, kationischen oder neutralen Farbstoff und einen Coinitiator umfassen.

Die Photopolymer-Formulierung kann zusätzlich eine nicht photopolymerisierbare Komponente D) als Weichmacher enthalten. Dabei kann der Weichmacher bevorzugt so ausgewählt werden, dass der Brechungsindex des Weichmachers mindestens um 0,05 Einheiten kleiner als der Brechungsindex der Matrixpolymere ist, wenn beide Schreibmonomere höhere Brechungsindizes als die Matrixpolymere besitzen und der Brechungsindex des Weichmachers um mindestens 0,05 Einheiten größer als der Brechungsindex der Matrixpolymere ist, wenn beide Schreibmonomere Brechungsindizes kleiner als der Brechungsindex der Matrixpolymere besitzen.

Als Weichmacher können insbesondere Urethane der allgemeinen Formel (VI)

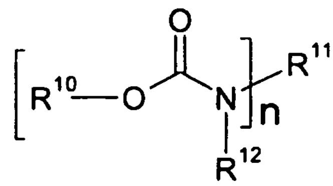

(VI)

verwendet werden, bei denen n≥ 1 und n≤8 ist und $R^{10}$, $R^{11}$, $R^{12}$ Wasserstoff und / oder unabhängig voneinander lineare, verzweigte, cyclische oder heterocyclische unsubstituierte oder gegebenenfalls auch mit Heteroatomen substituierte organische Reste sind, wobei bevorzugt mindestens einer der Reste $R^{10}$, $R^{11}$, $R^{12}$ mit wenigstens einem Fluoratom substituiert ist und besonders bevorzugt $R^{10}$ ein organischer Rest mit mindestens einem Fluoratom ist.

Weitere Bestandteile E) der Photopolymer-Formulierung können sein: Radikalstabilisatoren, gegebenenfalls Katalysatoren oder andere Hilfs- und Zusatzstoffe.

Als Beispiele für Radikalstabilisatoren sind Inhibitoren und Antioxidantien wie sie z.B. in "Methoden der organischen Chemie" (Houben-Weyl), 4. Auflage, Band XIV/1, S. 433ff, Georg Thieme Verlag, Stuttgart 1961, beschrieben sind, geeignet. Geeignete Stoffklassen sind beispielsweise Phenole wie z.B. 2,6-Di-tert-butyl-4-methylphenol, Kresole, Hydrochinone, Benzylalkohole wie z.B. Benzhydrol, ggf. auch Chinone wie z. B. 2,5-Di-tert.-Butylchinon, ggf. auch aromatische Amine wie Diisopropylamin oder Phenothiazin.

Bevorzugt sind 2,6-Di-tert.-butyl-4-methylphenol, Phenothiazin, p-Methyoxyphenol, 2-Methoxy-p-hydrochinon und Benzhydrol.

Gegebenenfalls können ein oder mehrere Katalysatoren eingesetzt werden. Dabei handelt es sich um Katalysatoren zur Beschleunigung der Urethanbildung. Bekannte Katalysatoren hierfür sind beispielsweise Zinnoctoat, Zinkoktoat, Dibutylzinndilaurat, Dimethylbis[(1-oxoneodecyl)oxy]stannan, Dimethylzinndicarboxylat, Zirkonium-bis (ethylhexanoat), Zirconiumacteylacetonat oder tertiäre Aminen wie beispielsweise 1,4-Diazabicyclo[2.2.2]octan, Diazabicyclononan, Diazabicycloundecan, 1,1,3,3-Tetramethylguanidin, 1,3,4,6,7,8-Hexahydro-1-methyl-2H-pyrimido(1,2-a)pyrimidin.

Bevorzugt sind Dibutylzinndilaurat, Dimethylbis[(1-oxoneodecyl)oxy]stannan, Dimethylzinndicarboxylat, 1,4-Diazabicyclo[2.2.2]octan, Diazabicyclononan, Diazabicycloundecan, 1,1,3,3-Tetramethylguanidin, 1,3,4,6,7,8-Hexahydro-1-methyl-2H-pyrimido(1,2-a)pyrimidin.

Selbstverständlich können gegebenenfalls weitere Hilfs- oder Zusatzstoffe eingesetzt werden. Dabei kann es sich beispielsweise um im Bereich der Lacktechnologie gängige Zusatzstoffe wie Lösemittel, Weichmacher, Verlaufsmittel oder Haftvermittler handeln. Es kann auch von Vorteil sein, gleichzeitig mehrere Zusatzstoffe eines Typs zu verwenden. Selbstverständlich kann es ebenfalls von Vorteil sein, mehrere Zusatzstoffe mehrerer Typen zu verwenden.

Gemäß einer weiteren bevorzugten Ausführungsform ist vorgesehen, dass der Brechungsindexkontrast An von einzelnen belichteten, holographischen Medien mit unterschiedlichen Anteilen an monofunktionellen und multifunktionellen Schreibmonomeren um weniger als 55% variiert, wobei die Variation wie folgt zu berechnen ist: $(\Delta n_{max} - \Delta n_{min}) / \Delta n_{min} \cdot 1\,00\%$.

Es ist ebenfalls möglich eine Schicht aus der Photopolymer-Formulierung im Schritt ii) mit einem Substrat zu verbinden. Zusätzlich kann die Schicht aus der Photopolymer-Formulierung mit einem weiteren Substrat verbunden werden.

Vorzugsweise können die Beschichtung und das oder die Substrate durch Laminieren oder Verkleben miteinander verbunden werden.

Ein weiterer Gegenstand der Erfindung ist ein belichtetes holographisches Medium, dass nach dem erfindungsgemäßen Verfahren erhältlich ist.

**Beispiele:**

Die Erfindung wird im Folgenden anhand von Beispielen näher erläutert.

**Bezeichnungen die im folgenden Verwendung finden:**

Photopolymerformulierungen umfassend:

- Dreidimensional vernetzte organische Polymere A) als Matrix. Besonders bevorzugt sind solche dreidimensional vernetzte organische Polymere, welche als Vorstufen aus

o einer Isocyanatkomponente a)

o und einer Isocyanat-reaktiven Komponente b) aufgebaut sind und

o mit Hilfe einer Katalysator Komponente E) vernetzt werden, der in der Regel in Lösung zugegeben wird,

- Verbindungen B), die unter Einwirkung aktinischer Strahlung mit ethylenisch ungesättigten Verbindungen unter Polymerisation reagierende Gruppen (strahlenhärtende Gruppen) aufweisen und in dieser Matrix gelöst oder verteilt vorliegen
- wenigstens einen Photoinitiator C).
- optional eine nicht photopolymerisierbare Komponente D).
- gegebenenfalls Katalysatoren, Radikalstabilisatoren, Lösungsmittel, Additive sowie andere Hilfs- und / oder Zusatzstoffe E)
- F bezeichnet die Photopolymerformulierung mit 0.1 gew. % Darocur TPO als UV-Initiator C4) die für die Bestimmung des UV Moduls $G_{UV}$ verwendet wird.
- M bezeichnet das holographische Medium aus der entsprechenden Photopolymerformulierung F aber in der Darocure TPO durch den entsprechenden Photoinitiator C) für den sichtbaren Bereich ersetzt wurde.

**Messmethoden:**

Sofern nicht abweichend vermerkt beziehen sich alle Prozentangaben auf Gewichtsprozent.

**Messung der Brechungsindizes der photopolymerisierbaren Schreibmonomere B) und der nicht photopolymerisierbaren Komponenten D)**

Der Brechungsindex n in Abhängigkeit von der Wellenlänge der Proben wurden aus den Transmissions- und Reflexionsspektren erhalten. Dazu wurden ca. 100 - 300 nm dicke Filme der Proben auf Quarzglasträger aus verdünnter Lösung in Butylacetat aufgeschleudert. Das Transmissions- und Reflexionsspektrum dieses Schichtpaketes wurde mit einem Spektrometer der Firma STEAG ETA-Optik, CD-Measurement System ETA-RT gemessen und danach die Schichtdicke und der spektrale Verlauf von n an die gemessenen Transmissions- und Reflexionsspektren angepasst. Dies geschieht mit der internen Software des Spektrometers und erfordert zusätzlich die Brechungsindexdaten des Quarzglassubstrates, die in einer Blindmessung vorab bestimmt wurden. Die Brechungsindizes $n_{Mo}$ für die photopolymerisierbaren Monomere B) bzw. $n_{CA}$ für die nicht photopolymerisierbaren Komponenten D) beziehen sich auf die Wellenlänge einer Natriumdampflampe von 589 nm und entspricht damit $n_D^{20}$. Die erhaltenen Brechungsindizes findet man in Tabelle 1.

**Messung der Brechungsindizes der Matrixkomponente A), basierend auf einem polymeren Urethan-Netzwerk**

Zur Herstellung der Photopolymermatrizes zur Bestimmung des Brechungsindexes $n_{Ma}$ wird die Isocyanatreaktive Komponente b) gegebenenfalls auf 60 °C erhitzt. Dann wird die Isocyanatkomponente a) zugegeben und im Speedmixer (Firma Hauschild) 1 Minute gemischt. Im Folgenden wird eine Lösung der Komponente E) zugegeben und im Speedmixer erneut 1 Minute gemischt. Die Lösung der Komponente E) ist 10 Gewichtsprozent in n-Ethyl-Pyrrolidon. Die entsprechend verwendeten Mengen Lösung und die erhaltenen Brechungsindizes findet man in Tabelle 1. Die noch flüssige Formulierung wird in der gewünschten Dicke auf Glasplatten aufgerakelt.

Die auf einem polymeren Netzwerk basierende Matrix wurde als ca. 500 μm bis 1000 μm dicke Schicht auf einem Glasträger präpariert. An dieser Probe wurde mittels eines Abbe Refraktometers analog zu DIN 51423-2 der Brechungsindex $n_{Ma}$ bei der Wellenlänge der Natriumdampflampe von 589 nm bestimmt und entspricht damit $n_D^{20}$.

**Messung der Glastemperaturen $T_G$ der verschiedenen Komponenten**

Zur Bestimmung der Glastemperatur $T_G$ wurden ~ 10 mgr der Substanz in Aluminium Tiegel eingewogen der mit einem gelochten Deckel verschlossen wird. Die Glastemperatur wird dann an den so präparierten Proben mit einem Differential Scanning Kalorimeter DSC822$^e$/400 der Fa. Mettler-Toledo bestimmt. Es werden drei Aufheizzyklen mit

einer Heizrate von 20 K/min gefahren. Die Start und Endtemperatur des ersten Zyklus beträgt -100°C bzw. 80°C. Die Start und Endtemperaturen des zweiten und dritten Zykluses betragen -100°C bzw. 150°C. Die entsprechenden Kühlraten betragen 50 K/min. Der Ofen und die Probe des Kalorimeters werden mit einem Stickstoffstrom von 20 ml/min Fluss durchspült. Als $T_G$ der Probe wird die Glastemperatur beim 3. Aufheizzyklus ermittelt.

**Messung der holographischen Eigenschaften DE und $\Delta n$ der holographischen Medien mittels Zweistrahlinterferenz in Reflexionsanordnung**

Die wie im Abschnitt "Herstellung der holographischen Medien basierend auf Photopolymerformulierung mit Photoinitiator zur Bestimmung der Performance Parameter DE und $\Delta n$" beschrieben hergestellten Medien wurden anschließend mittels einer Messanordnung gemäß Figur 1 wie folgt auf ihre holographischen Eigenschaften geprüft:

Der Strahl eines He-Ne Lasers (Emissionswellenlänge 633 nm) wurde mit Hilfe des Raumfilter (SF) und zusammen mit der Kollimationslinse (CL) in einen parallelen homogenen Strahl umgewandelt. Die finalen Querschnitte des Signal und Referenzstrahls werden durch die Irisblenden (I) festgelegt. Der Durchmesser der Irisblendenöffnung beträgt 0.4 cm. Die polarisationsabhängigen Strahlteiler (PBS) teilen den Laserstrahl in zwei kohärente gleich polarisierte Strahlen. Über die $\lambda/2$ Plättchen wurden die Leistung des Referenzstrahls auf 0.5 mW und die Leistung des Signalstrahls auf 0.65 mW eingestellt. Die Leistungen wurden mit den Halbleiterdetektoren (D) bei ausgebauter Probe bestimmt. Der Einfallswinkel ($\alpha_0$) des Referenzstrahls beträgt -21.8°, der Einfallswinkel ($\beta_0$) des Signalstrahls beträgt 41.8°. Die Winkel werden ausgehend von der Probennormale zur Strahlrichtung gemessen. Gemäß Figur 1 hat daher $\alpha_0$ ein negatives Vorzeichen und $\beta_0$ ein positives Vorzeichen. Am Ort der Probe (Medium) erzeugte das Interferenzfeld der zwei überlappenden Strahlen ein Gitter heller und dunkler Streifen die senkrecht zur Winkelhalbierenden der zwei auf die Probe einfallenden Strahlen liegen (Reflexionshologramm). Der Streifenabstand A, auch Gitterperiode genannt, im Medium beträgt ~ 225 nm (der Brechungsindex des Mediums zu ~ 1.504 angenommen).

Figur 1 zeigt die Geometrie eines Holographic Media Testers (HMT) bei $\lambda$ = 633 nm (He-Ne Laser): M = Spiegel, S = Verschluss, SF = Raumfilter, CL = Kollimatorlinse, $\lambda/2$ = $\lambda/2$ Platte, PBS = polarisationsempfindlicher Strahlteiler, D = Detektor, 1 = Irisblende, $\alpha_0$ = -21.8°, $\beta_0$ = 41.8° sind die Einfallswinkel der kohärenten Strahlen außerhalb der Probe (des Mediums) gemessen. RD = Referenzrichtung des Drehtisches.

Mit einem holographischen Versuchsaufbau wie in Figur 1 dargestellt wurden die Beugungseffizienz (DE) der Medien gemessen.

Es wurden auf folgende Weise Hologramme in das Medium geschrieben:

- Beide Shutter (S) sind für die Belichtungszeit *t* geöffnet.
- Danach wurde bei geschlossenen Shuttem (S) dem Medium 5 Minuten Zeit für die Diffusion der noch nicht polymerisierten Schreibmonomere gelassen.

Die geschriebenen Hologramme wurden nun auf folgende Weise ausgelesen. Der Shutter des Signalstrahls blieb geschlossen. Der Shutter des Referenzstrahls war geöffnet. Die Irisblende des Referenzstrahls wurde auf einen Durchmesser < 1 mm geschlossen. Damit erreichte man, dass für alle Drehwinkel ($\Omega$) des Mediums der Strahl immer vollständig im zuvor geschriebenen Hologramm lag. Der Drehtisch überstrich nun computergesteuert den Winkelbereich von $\Omega_{min}$ bis $\Omega_{ma}$, mit einer Winkelschrittweite von 0.05°. $\Omega$ wird von der Probennormale zur Referenzrichtung des Drehtisches gemessen. Die Referenzrichtung des Drehtisches ergibt sich dann wenn beim Schreiben des Hologramms der Einfallswinkel des Referenz- und des Signalstrahls betragsmäßig gleich sind also $\alpha_0$ = -31.8° und $\beta_0$ = 31.8° gilt. Dann beträgt $\Omega_{recording}$ = 0°. Für $\alpha_0$ = -21.8° und $\beta_0$ = 41.8° beträgt $\Omega_{recording}$ daher 10°. Allgemein gilt für das Interferenzfeld beim Schreiben ("recording") des Hologramms:

$$\alpha_0 = \theta_0 + \Omega_{recording}.$$

$\theta_0$ ist der Halbwinkel im Laborsystem außerhalb des Mediums und es gilt beim Schreiben des Hologramms:

$$\theta_0 = \frac{\alpha_0 - \beta_0}{2}.$$

In diesem Fall gilt also $\theta_0$ = -31.8°. An jedem angefahrenen Drehwinkel $\Omega$ wurden die Leistungen des in der

nullten Ordnung transmittierten Strahls mittels des entsprechenden Detektors D und die Leistungen des in die erste Ordnung abgebeugten Strahls mittels des Detektors D gemessen. Die Beugungseffizienz ergab sich bei jedem angefahrenen Winkel Ω als der Quotient aus:

$$\eta = \frac{P_D}{P_D + P_T}$$

$P_D$ ist die Leistung im Detektor des abgebeugten Strahls und $P_T$ ist die Leistung im Detektor des transmittierten Strahls.

Mittels des oben beschriebenen Verfahrens wurde die Braggkurve, sie beschreibt den Beugungswirkungsgrad η in Abhängigkeit des Drehwinkels Ω, des geschriebenen Hologramms gemessen und in einem Computer gespeichert. Zusätzlich wurde auch die in die nullte Ordnung transmittierte Intensität gegen den Drehwinkel Ω aufgezeichnet und in einem Computer gespeichert.

Die maximale Beugungseffizienz (DE = $\eta_{max}$) des Hologramms, also sein Spitzenwert, wurde bei $\Omega_{reconstruction}$ ermittelt. Eventuell musste dazu die Position des Detektors des abgebeugten Strahls verändert werden, um diesen maximalen Wert zu bestimmen.

Der Brechungsindexkontrast Δn und die Dicke *d* der Photopolymerschicht wurde nun mittels der Coupled Wave Theorie (siehe; H. Kogelnik, The Bell System Technical Journal, Volume 48, November 1969, Number 9 Seite 2909 - Seite 2947) an die gemessene Braggkurve und den Winkelverlauf der transmittierten Intensität ermittelt. Dabei ist zu beachten, dass wegen der durch die Photopolymerisation auftretenden Dickenschwindung der Streifenabstand /\' des Hologramms und die Orientierung der Streifen (slant) vom Streifenabstand Λ des Interferenzmusters und dessen Orientierung abweichen kann. Demnach wird auch der Winkel $\alpha_0$' bzw. der entsprechende Winkel des Drehtisches $\Omega_{reconstruction}$, bei dem maximale Beugungseffizienz erreicht wird von $\alpha_0$ bzw. vom entsprechenden $\Omega_{recording}$ abweichen. Dadurch verändert sich die Bragg-Bedingung. Diese Veränderung wird im Auswerteverfahren berücksichtigt. Das Auswerteverfahren wird im Folgenden beschrieben:

Alle geometrischen Größen, die sich auf das geschriebene Hologramm beziehen und nicht auf das Interferenzmuster werden als gestrichene Größen dargestellt.

Für die Braggkurve η(Ω) eines Reflexionshologramms gilt nach Kogelnik:

$$\eta = \begin{cases} \dfrac{1}{1 - \dfrac{1-(\xi/\nu)^2}{\sin^2\left(\sqrt{\xi^2 - \nu^2}\right)}}, \text{ für } \nu^2 - \xi^2 < 0 \\ \dfrac{1}{1 + \dfrac{1-(\xi/\nu)^2}{\sinh^2\left(\sqrt{\nu^2 - \xi^2}\right)}}, \text{ für } \nu^2 - \xi^2 \geq 0 \end{cases}$$

mit:

$$\nu = \frac{\pi \cdot \Delta n \cdot d'}{\lambda \cdot \sqrt{|c_s \cdot c_r|}}$$

$$\xi = -\frac{d'}{2 \cdot c_s} \cdot DP$$

$$c_s = \cos(\vartheta') - \cos(\psi') \cdot \frac{\lambda}{n \cdot \Lambda'}$$

$$c_r = \cos(\vartheta')$$

$$DP = \frac{\pi}{\Lambda'} \cdot \left( 2 \cdot \cos(\psi' - \vartheta') - \frac{\lambda}{n \cdot \Lambda'} \right)$$

$$\psi' = \frac{\beta' + \alpha'}{2}$$

$$\Lambda' = \frac{\lambda}{2 \cdot n \cdot \cos(\psi' - \alpha')}$$

Beim Auslesen des Hologramms ("reconstruction") gilt wie analog oben dargestellt:

$$\vartheta'_0 = \theta_0 + \Omega$$

$$\sin(\vartheta'_0) = n \cdot \sin(\vartheta')$$

An der Bragg-Bedingung ist das "Dephasing" *DP* = 0. Und es folgt entsprechend:

$$\alpha'_0 = \theta_0 + \Omega_{reconstruction}$$

$$\sin(\alpha'_0) = n \cdot \sin(\alpha')$$

Der noch unbekannt Winkel β' kann aus dem Vergleich der Bragg-Bedingung des Interferenzfeldes beim Schreiben des Hologramms und der Bragg-Bedingung beim Auslesen des Hologramms ermittelt werden unter der Annahme, dass nur Dickenschwindung stattfindet. Dann folgt:

$$\sin(\beta') = \frac{1}{n} \cdot \left[ \sin(\alpha_0) + \sin(\beta_0) - \sin(\theta_0 + \Omega_{reconstruction}) \right]$$

ν ist die Gitterstärke, ξ ist der Detuning Parameter und ψ' die Orientierung (Slant) des Brechungsindexgitters das geschrieben wurde. α' und β' entsprechen den Winkeln $\alpha_0$ und $\beta_0$ des Interferenzfeldes beim Schreiben des Hologramms, aber im Medium gemessen und für das Gitter des Hologramms gültig (nach Dickenschwindung). n ist der mittlere Brechungsindex des Photopolymers und wurde zu 1.504 gesetzt. λ ist die Wellenlänge des Laserlichts im Vakuum.

Die maximale Beugungseffizienz (DE = $\eta_{max}$) ergibt sich dann für $\xi$ = 0 zu:

$$DE = \tanh^2(\nu) = \tanh^2\left(\frac{\pi \cdot \Delta n \cdot d'}{\lambda \cdot \sqrt{\cos(\alpha')\cdot\cos(\alpha'-2\psi)}}\right)$$

Figur 2 zeigt die gemessene transmittierte Leistung $P_T$ (rechte $\gamma$-Achse) als durchgezogene Linie gegen das Winkeldetuning $\Delta\Omega$ aufgetragen, die gemessene Beugungseffizienz $\eta$ (linke $\gamma$-Achse) als ausgefüllte Kreise gegen das Winkeldetuning $\Delta\Omega$ aufgetragen (soweit die endliche Größe des Detektors es erlaubte) und die Anpassung der Kogelnik Theorie als gestrichelte Linie (linke $\gamma$-Achse).

Die Messdaten der Beugungseffizienz, die theoretische Braggkurve und die transmittierte Intensität werden wie in Figur 2 gezeigt gegen den zentrierten Drehwinkel $\Delta\Omega \equiv \Omega_{reconstruction} - \Omega = \alpha'_0 - \vartheta'_0$, auch Winkeldetuning genannt, aufgetragen.

Da DE bekannt ist wird die Form der theoretischen Braggkurve nach Kogelnik nur noch durch die Dicke *d'* der Photopolymerschicht bestimmt. $\Delta$n wird über DE für gegebene Dicke *d'* so nachkorrigiert, dass Messung und Theorie von DE immer übereinstimmen. *d'* wird nun solange angepasst bis die Winkelpositionen der ersten Nebenminima der theoretischen Braggkurve mit den Winkelpositionen der ersten Nebenmaxima der transmittierten Intensität übereinstimmen und zudem die volle Breite bei halber Höhe (FWHM) für die theoretische Braggkurve und für die transmittierte Intensität übereinstimmen.

Da die Richtung in der ein Reflexionshologramm bei der Rekonstruktion mittels eines $\Omega$-Scans mitrotiert, der Detektor für das abgebeugte Licht aber nur einen endlichen Winkelbereich erfassen kann, wird die Braggkurve von breiten Holgrammen (kleines *d'*) bei einem $\Omega$-Scan nicht vollständig erfasst, sondern nur der zentrale Bereich, bei geeigneter Detektorpositionierung. Daher wird die zur Braggkurve komplementäre Form der transmittierten Intensität zur Anpassung der Schichtdicke *d'* zusätzlich herangezogen.

Figur 2 zeigt die Darstellung der Braggkurve $\eta$ nach der Coupled Wave Theorie (gestrichelte Linie), des gemessenen Beugungswirkungsgrades (ausgefüllte Kreise) und der transmittierten Leistung (schwarz durchgezogene Linie) gegen das Winkeldetuning $\Delta\Omega$.

Für eine Formulierung wurde diese Prozedur eventuell mehrfach für verschiedene Belichtungszeiten *t* an verschiedenen Medien wiederholt, um festzustellen bei welcher mittleren Energiedosis des einfallenden Laserstrahls beim Schreiben des Hologramms DE in den Sättigungswert übergeht. Die mittlere Energiedosis E ergibt sich wie folgt aus den Leistungen der zwei den Winkeln $\alpha_0$ und $\beta_0$ zugeordneten Teilstrahlen (Referenzstrahl mit $P_r$ = 0.50 mW und Signalstrahl mit $P_s$ = 0.63 mW), der Belichtungszeit t und dem Durchmesser der Irisblende (0.4 cm):

$$E\,(\mathrm{mJ/cm^2}) = \frac{2\cdot[P_r + P_s]\cdot t\,(\mathrm{s})}{\pi\cdot 0.4^2\ \mathrm{cm}^2}$$

Die Leistungen der Teilstrahlen wurden so angepasst, dass in dem Medium bei den verwendeten Winkeln $\alpha_0$ und $\beta_0$, die gleiche Leistungsdichte erreicht wird.

Als Alternative wurde auch ein dem in Figur 1 dargestellten Aufbau äquivalenter Test mit einem grünen Laser mit der Emissionswellenlänge $\lambda$ im Vakuum von 532 nm durchgeführt. Dabei beträgt $\alpha_0$ = -11.5° und $\beta_0$ = 33.5° und $P_r$ = 1.84 mW und $P_s$=2.16 mW.

**Messung des Moduls $G_{UV}$ der Photopolymeren nach UV Vernetzung mittels eines Oszillationsrheometers im Rahmen der vorliegenden Erfindung**

Die noch flüssige Formulierung (F) wird dann in das Platte - Platte Messsystem eines Rheometers (Firma Anton Paar Physica Modell MCR 301 ausgerüstet mit dem Ofenmodel CTD 450L+R+L+PP/GL ausgerüstet mit transparenter Basisplatte im Platte-Platte Messsystem der auf 50°C vorgeheizt war) eingebracht. Dann wird die Aushärtung der Matrix der Photopolymerformulierung zunächst über die Zeit unter folgenden Bedingungen gemessen:

- Plattenabstand 250$\mu$m, Plattendurchmesser 12 mm.

- Messmodus Oszillation bei einer konstanten Kreisfrequenz $\omega_0$ von 62.8 rad/s und einer geregelten logarithmischen Deformationsamplitudenrampe von 10% - 0.0,1%.

- Temperatur 50°C, Normalkraftregelung auf 0 Newton eingestellt

- Aufzeichnung des Speichermoduls G' über der Messzeit für mindestens 2 Stunden oder bis ein konstanter Wert von G' erreicht wurde. Dieser Wert wird $G_0$ genannt.

Die UV-Aushärtung des Photopolymeren wird mit einer 100 W Hochdruck-Quecksilberdampflampe OmniCure Series 1000 ausgerüstet mit Standard-Filter 320 nm - 500 nm.

- Belichtung des Photopolymeren durch die transparente untere Platte mit einer Quecksilberdampflampe. Die Blende am Ausgang der Lampe wird so eingestellt, das die Leistungsdichte am Ausgang des Lichtleiters (gemessen mit mitgeliefertem EXFO - Radiometer R2000), der in die Messkammer eingeführt wird und das Licht zur transparenten Glasplatte führt 600 $mW/cm^2$ beträgt.

- Messmodus Oszillation bei einer konstanten Kreisfrequenz $\omega_0$ von 62.8 rad/s und einer geregelten logarithmischen Deformationsamplitudenrampe Deformationsamplitude von 0.01%-0.001%.

- Temperatur 50°C, Normalkraftregelung auf 0 Newton eingestellt

- Aufzeichnung des Speichermoduls G', während der UV Belichtung über der Messzeit für mindestens 15 Minuten oder bis ein konstanter Wert von G' erreicht wurde. Dieser Wert wird als $G_{uv}$ genommen.

Ein Beispiel für eine typische Messkurve findet sich in Figur 3. Figur 3 zeigt den Verlauf der Aushärtung des Matrixnetzwerkes (links) und der anschließenden W-Vernetzung (rechts), anhand des Speichermoduls G'.

**Beschreibung der in den Beispielen verwendeten Formulierungsbestandteile:**

**Verwendete Isocyanate (Komponente a))**

**Desmodur® XP 2599** ist ein Produkt der Bayer MaterialScience AG, Leverkusen, Deutschland, Vollallophanat von Hexandiisocyanat auf Acclaim 4200, NCO-Gehalt: 5,6 - 6,4 % (**Komponente a1**)).
**Desmodur® XP 2747** ist ein Produkt der Bayer MaterialScience AG, Leverkusen, Deutschland, Vollallophanat von Hexandiisocyanat auf Polypropylenglykol mit zahlenmittlerer Molmasse von ca. 280 g/mol, NCO-Gehalt: 16,5 - 17,3 % (**Komponente a2**)).
**Desmodur® XP 2410** ist ein Produkt der Bayer MaterialScience AG, Leverkusen, Deutschland, Hexandiisocyanat-basiertes Polyisocyanat, Anteil an Iminooxadiazindion mindestens 30 %, NCO-Gehalt: 23,5 % **(Komponente a3)).**
**Desmodur® XP 2580** ist ein Produkt der Bayer MaterialScience AG, Leverkusen, Deutschland, aliphatisches Polyisocyanat auf Basis von Hexandiisocyanat, NCO-Gehalt ca. 20 % **(Komponente a4)).**

**Verwendete isocyanatreaktiven Komponenten (Komponente b))**

**Acclaim® 4200** ist ein Handelsprodukt der Bayer MaterialScience AG, Leverkusen, Deutschland, Polypropylenoxid der zahlenmittleren Molmasse 4000 g/Mol **(Polyol b1)).**
**Polyol b2)** ist ein experimentelles Produkt der Bayer MaterialScience AG, Leverkusen, Deutschland, die Herstellung ist unten beschrieben.

<u>Herstellung von Polyol b2):</u>

In einen mit Rührwerk ausgestatteten 20 1 - Reaktionskessel wurden 2475 g Terathane® 650 (Polytetrahydrofuran mit Molmasse 650 gr/mol), ein Produkt der BASF SE, Ludwigshafen DE, eingewogen und 452,6 mg DMC-Katalysator zugegeben. Dann wurde unter Rühren bei ca. 70 U/min, auf 105 °C erhitzt. Durch dreimaliges Anlegen von Vakuum und Entspannen mit Stickstoff wurde Luft gegen Stickstoff ausgetauscht. Nach Erhöhung der Rührerdrehzahl auf 300 U/min.wurde für 57 Minuten bei laufender Vakuumpumpe und einem Druck von etwa 0,1 bar von unten Stickstoff durch die Mischung geleitet. Danach wurden mittels Stickstoff ein Druck von 0,5 bar eingestellt und 100 g Ethylenoxid (EO) und 150 g PO parallel zum Start der Polymerisation eingeleitet. Hierbei stieg der Druck auf 2,07 bar. Nach 10

Minuten war der Druck wieder auf 0,68 bar abgefallen und es wurden über einen Zeitraum von 1h 53 min. weitere 5,116 kg EO und 7,558 kg PO als Gemisch bei 2,34 bar zugeleitet. 31 Minuten nach Ende der Epoxiddosierung wurde bei einem Restdruck von 2,16 bar Vakuum angelegt und vollständig entgast. Der Produkt wurde durch Zugabe von 7,5 g Irganox 1076 stabilisiert und als, leicht trübe (TE(F)-Zahl 330), viskose Flüssigkeit erhalten (OH-Zahl 27,1 mg KOH/g, Viskosität bei 25 °C: 1636 mPas).

**Polyol b3)** ist ein experimentelles Produkt der Bayer MaterialScience AG, Leverkusen, Deutschland, Blockcopolymer von Terathane® 1000 (Polytetrahydrofuranpolyetherpolyol der Molmasse 1000 gr/mol), ein Produkt der BASF SE, Ludwigshafen DE, und ε-Caprolacton, die Herstellung ist unten beschrieben.

Herstellung von Polyol b3):

In einem 1 L Kolben wurden 0.18 g Zinnoktoat, 374.8 g ε-Caprolacton und 374.8 g eines difunktionellen Polytetrahydrofuranpolyetherpolyols (Equivalentgewicht 500 g/Mol OH) vorgelegt und auf 120 °C aufgeheizt und so lange auf dieser Temperatur gehalten, bis der Festgehalt (Anteil der nicht-flüchtigen Bestandteile) bei 99.5 Gew.-% oder darüber lag. Anschließend wurde abgekühlt und das Produkt als wachsiger Feststoff erhalten.

**Polyol b4)** ist ein experimentelles Produkt der Bayer MaterialScience AG, Leverkusen, Deutschland, die Herstellung ist unten beschrieben.

Herstellung von Polyol b4):

In einen mit Rührwerk ausgestatteten 20 1 - Reaktionskessel wurden 2465 g Terathane® 650 eingewogen und 450,5 mg DMC-Katalysator zugegeben. Dann wurde unter Rühren bei ca. 70 U/min. auf 105 °C erhitzt. Durch dreimaliges Anlegen von Vakuum und Entspannen mit Stickstoff wurde Luft gegen Stickstoff ausgetauscht. Nach Erhöhung der Rührerdrehzahl auf 300 U/min.wurde für 72 Minuten bei laufender Vakuumpumpe und einem Druck von etwa 0,1 bar von unten Stickstoff durch die Mischung geleitet. Danach wurden mittels Stickstoff ein Druck von 0,3 bar eingestellt und 242 g Propylenoxid (PO) zum Start der Polymerisation eingeleitet. Hierbei stieg der Druck auf 2,03 bar. Nach 8 Minuten war der Druck wieder auf 0,5 bar abgefallen und es wurden über einen Zeitraum von 2h 11 min. weitere 12,538 kg PO bei 2,34 bar eindosiert. 17 Minuten nach Ende der PO-Dosierung wurde bei einem Restdruck von 1,29 bar Vakuum angelegt und vollständig entgast. Der Produkt wurde durch Zugabe von 7,5 g Irganox 1076 stabilisiert und als farblose, viskose Flüssigkeit erhalten (OH-Zahl: 27,8 mg KOH/g, Viskosität bei 25 °C: 1165 mPas).

**Verwendeter Katalysator (Komponente E))**

**Fomrez® UL28:** Urethanisierungskatalysator, Dimethylbis[(1-oxoneodecl)oxy]stannan, Handelsprodukt der Fa. Momentive Performance Chemicals, Wilton, CT, USA als 10%ige Lösung in N-Ethylpyrrolidon eingesetzt **(Komponente E1)).**

**Verwendete strahlenhärtende Gruppen (Komponente B))**

**Komponente B1)** Phosphorthioyltris(oxy-4,1-phenyleniminocarbonyloxyethan-2,1-diyl)-triacrylat

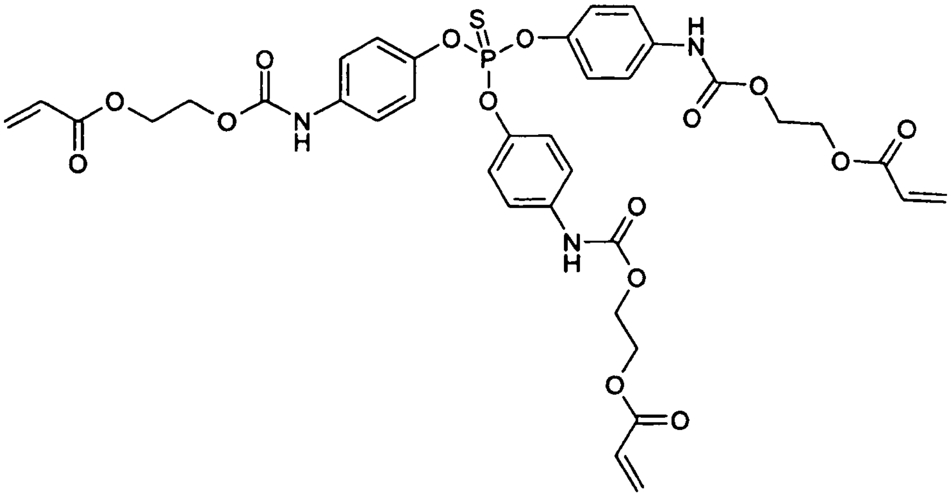

In einem 500 mL Rundkolben werden 0,1 g 2,6-Di-tert.butyl-4-methylphenol, 213,07 g einer 27% igen Lösung von Tris(p-isocyanatophenyl)thiophosphate in Ethylacetat (Desmodur RFE, Produkt der Bayer MaterialScience AG) vorgelegt und auf 60 °C erwärmt. Anschließend werden 42,37 g 2-Hydroxyethylacrylat zugetropft und die Mischung weiter auf 60 °C gehalten, bis der Isocyanatgehalt unter 0,1 % gesunken ist. Danach wird abgekühlt und im Vakuum das Ethylacetat vollständig entfernt. Das Produkt wird als teilkristalliner Feststoff erhalten.

Der Brechungsindex $n_{Mo}$ beträgt 1.579.

**Komponente B2)** 2-({[3-(Methylsulfanyl)phenyl]carbamoyl}oxy)ethylprop-2-enoat.

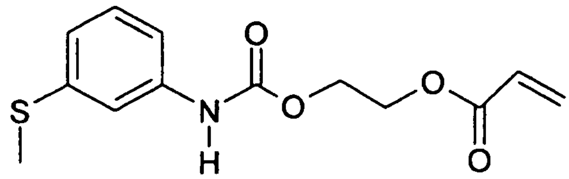

In einem 100 mL Rundkolben wurden 0.02 g 2,6-Di-tert.-butyl-4-methylphenol, 0.01 g Desmorapid Z, 11.7 g 3-(Methylthio)phenylisocyanat vorgelegt und vorgelegt und auf 60 °C erwärmt. Anschließend wurden 8.2 g 2-Hydroxyethylacrylat zugetropft und die Mischung weiter auf 60 °C gehalten, bis der Isocyanatgehalt unter 0.1 % gesunken war. Danach wurde abgekühlt. Das Produkt wurde als farblose Flüssigkeit erhalten.

Der Brechungsindex $n_{Mo}$ beträgt 1.576.

**Komponente B3) Sartomer®** SR349 Ethoxyliertes (3) bisphenol A diacrylate

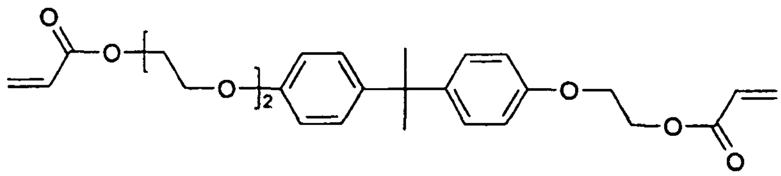

Sartomer® SR349 ist ein Produkt der Sartomer Company, 502 Thomas Jones Way Exton, PA 19341 (USA).

Der Brechungsindex $n_D^{20} = n_{Mo}$ beträgt 1.543 (Angaben im Datenblatt des Herstellers).

**Komponente B4)** Mischung aus 3-[(2-Methylacryloyl)oxy]-2-[(3-methylthiophenylcarbamoyl)oxy]propyl naphthalene-1-carboxylat

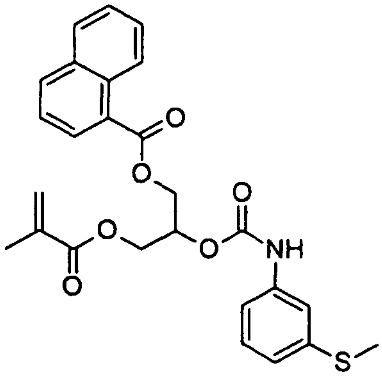

und 2-[(2-Methylacryloyl)oxy]-1-([(3-methylthiophenylcarbamoyl)oxy]methyl)ethyl naphthalene-1-carboxylat

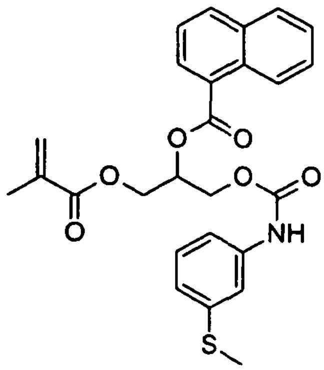

9,4 g des Produktes aus Beispiel 1.1 und 1mg Dibutylzinndilaurat werden bei 60 °C in einem Dreihalskolben mit Rührer und Rückflußkühler vorgelegt und es wird langsam Luft durchgeleitet. Innerhalb von 25 Minuten werden nun unter Exothermie 5,0g m-Methylthiophenylisocyanat zugetropft. Man rührt weiter für 21 Stunden und erhält ein klares, gelbliches Produkt mit einem NCO-Gehalt von 0%..
Der Brechungsindex $n_{Mo}$ beträgt 1.617.

**Komponente B5)** {[4-({[(1,1,1,3,3,3-Hexafluorpropan-2-yl)oxy]carbonyl}amino)phenoxy]-phosphorothioyl}bis(oxybenzol-4,1-diylcarbamoyloxyethan-2,1-diyl)bisacrylat.

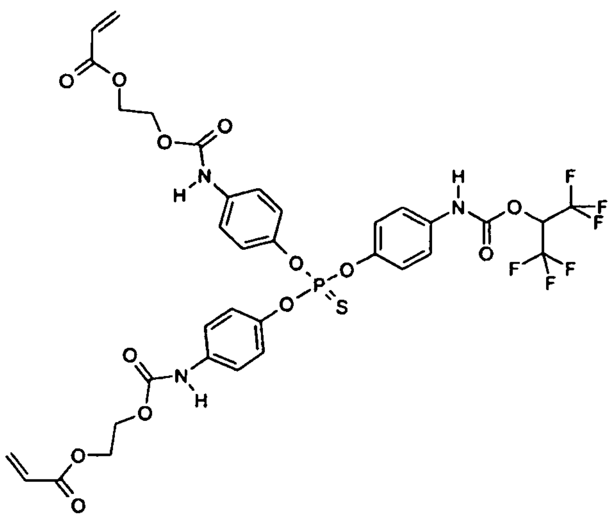

In einem 2 L Rundkolben wurden 0.5 g 2,6-Di-tert.-butyl-4-methylphenol, 0.25 g Dibutylzinndilaurat (Desmorapid Z, Bayer MaterialScience AG, Leverkusen, Deutschland) sowie und 1.00 kg einer 27 %-igen Lösung von Tris(p-isocyanatophenyl)thiophosphat in Ethylacetat (Desmodur® RFE, Produkt der Bayer MaterialScience AG, Leverkusen, Deutschland) vorgelegt und auf 60 °C erwärmt. Anschließend wurden 95.3 g Hexafluoro-isopropanol zugetropft und die Temperatur für 8 h gehalten. Anschließend wurden 133.5. g 2-Hydroxyethylacrylat zugetropft und die Mischung weiter auf 60 °C gehalten, bis der Isocyanatgehalt unter 0.1 % gesunken war. Danach wurde abgekühlt und im Vakuum das Ethylacetat vollständig entfernt. Das Produkt wurde als farbloses Öl erhalten.

Der Brechungsindex $n_{mo}$ beträgt 1.584.

**Komponente B6)** Eine Mischung aus (4-Methylbenzol-1,3-diyl)bis[carbamoyloxy-3-(biphenyl-2-yloxy)propan-2,1-diyl] bisacrylat und (4-Methylbenzol-1,3-diyl)bis[carbamoyloxy-3-(biphenyl-2-yloxy)propan-1,2-diyl]bisacrylat und analoger Isomere

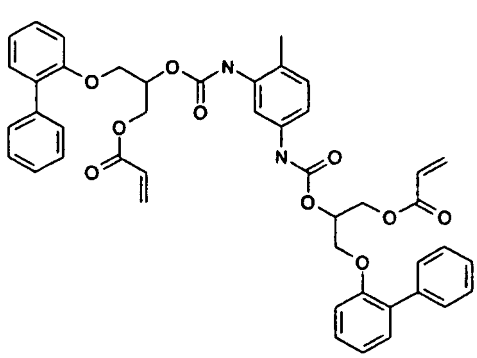

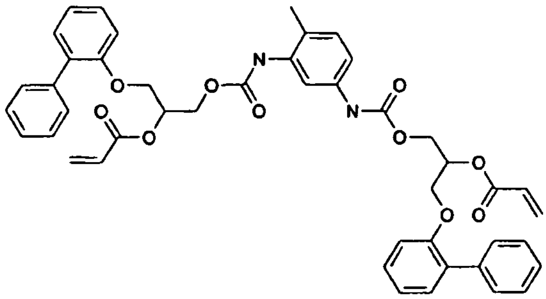

Vorprodukt Komponente B6.1: 430,2g Denacol EX 142 (Nagase-Chemtex, Japan), 129,7g Acrylsäure, 1,18g Triphenylphosphin und 0,0056g 2,6-Di-t.-butyl-4-methylphenol wurden in einem Dreihalskolben mit Rückflusskühler und Rührwerk vorgelegt. Zudem wurde Luft langsam durchgeleitet und auf 60 °C temperiert. Anschließend wird für 24 Stunden bei 90 °C gerührt. Man erhielt eine klare Flüssigkeit mit OHZ=157,8 mg KOH/g.

21,3g des Vorproduktes aus Komponente B6.1 und 5,2g eines Gemischs aus 2,4 und 2,6-Toluidendiisocyanat (Desmodur T80, Bayer MaterialScience AG, Leverkusen, Germany) wurden in einem Dreihalskolben mit Rückflusskühler und Rührwerk vorgelegt. Zudem wurde Luft langsam durchgeleitet und auf 60 °C temperiert. Nach anfänglicher Exothermie das Produkt für 24 Stunden bei 60 °C gerührt. Es wurde ein klares, farbloses, gläsernes Produkt mit NCO = 0% erhalten.

Der Brechungsindex $n_{mo}$ beträgt 1.611.

**Verwendete Photoinitiatorsysteme (Komponente C))**

Beschreibung des Systems **Neu Methylenblau + CGI** 909 **(Komponente C1))**

In einem Becherglas werden im Dunkeln oder unter geeigneter Beleuchtung 0.1g Neu Methylenblau, 1.00 g CGI 909 ((Tetrabutylammonium-tris(3-chlor-4-methylphenyl)(hexyl)borat, [1147315-11-4]) ist ein von der Ciba Inc., Basel, Schweiz, hergestelltes Versuchsprodukt) in 3.50 g N-Ethylpyrolidon gelöst. Von dieser Lösung werden die entsprechenden Gewichtsprozente zur Erstellung der Beispielmedien verwendet.

**Beschreibung des Systems Safranin O + CGI (Komponente C2))**

In einem Becherglas werden im Dunkeln oder unter geeigneter Beleuchtung 0.1g Safranin O, 1.00 g CGI 909 ((Tetrabutylammonium-tris(3-chlor-4-methylphenyl)(hexyl)borat, [1147315-11-4]) ist ein von der Ciba Inc., Basel, Schweiz, hergestelltes Versuchsprodukt) in 3.50 g N-Ethylpyrolidon gelöst. Von dieser Lösung werden die entsprechenden Gewichtsprozente zur Erstellung der Beispielmedien verwendet.

Beschreibung des Systems **Neu Methylenblau + Safranin O + CGI** 909 **(Komponente C3))**

Die Komponente C3 ist eine 1 zu 1 Mischung aus Komponente C1 und Komponente C2. Von dieser Lösung werden die entsprechenden Gewichtsprozente zur Erstellung der Beispielmedien verwendet.

Beschreibung des UV-Initiators **TPO (Komponente C4))**

Darocur® TPO (Diphenyl (2,4,6-trimethylbenzoyl)-phosphine oxide) ist ein Produkt der Fa. Ciba Inc., Basel, Schweiz. Von diesem Produkt werden die entsprechenden Gewichtsprozente zur Erstellung der Beispielmedien im Dunkeln oder unter geeigneter Beleuchtung eingewogen.

**Verwendete nicht photopolymerisierbare Komponenten (Komponente D))**

Beschreibung von **Komponente D1)** Bis(2,2,3,3,4,4,5,5,6,6,7,7-dodecafluorheptyl)-(2,2,4-trimethylhexan-1,6-diyl)biscarbamat

In einem 50 mL Rundkolben wurden 0.02 g Desmorapid Z und 3.6 g 2,4,4-Trimethylhexane-1,6-diisocyanat (TMDI) vorgelegt und auf 60 °C erwärmt. Anschließend wurden 11.9 g 2,2,3,3,4,4,5,5,6,6,7,7-Dodecafluorheptan-1-ol

zugetropft und die Mischung weiter auf 60 °C gehalten, bis der Isocyanatgehalt unter 0.1 % gesunken war. Danach wurde abgekühlt. Das Produkt wurde als farbloses Öl erhalten.

Der Brechungsindex $n_D^{20} = n_{CA}$ beträgt 1.384

Beschreibung von **Komponente D2)** 2,2,3,3,4,4,5,5,6,6,7,7,8,8,9,9-Hexadecafluornonylbutylcarbamat

In einem 1 L Rundkolben wurden 0.50 g Desmorapid Z und 186 g n-Butylisocyanat vorgelegt und auf 60 °C erwärmt. Anschließend wurden 813 g 2,2,3,3,4,4,5,5,6,6,7,7,8,8,9,9-Hexadecafluornonanol zugetropft und die Mischung weiter auf 60 °C gehalten, bis der Isocyanatgehalt unter 0.1 % gesunken war. Danach wurde abgekühlt. Das Produkt wurde als farbloses Öl erhalten.

Der Brechungsindex $n_D^{20} = n_{CA}$ beträgt 1.356

**Zusammensetzungen und Herstellung der Proben und Beispielmedien:**

**Herstellung der Proben zur Bestimmung des Brechungsindexes und der Glastemperatur**

Folgende dreidimensional vernetzte Polymere als Matrix Komponente A) der Photopolymerformulierung zur Bestimmung des Brechungsindexes $n_{Ma}$ wurden nach dem oben beschriebenen Verfahren hergestellt und vermessen. Ebenso wurden die Brechungsindizes $n_{Mo}$ bzw. $n_{CA}$ der photopolymerisierbaren Monomere Komponenten B) bzw. der nicht photopolymerisierbaren Komponenten D) wie oben beschrieben experimentell bestimmt. Tabelle 1 beschreibt die genauen Zusammensetzungen und Ergebnisse. NCO:OH bezeichnet das Äquivalentverhältnis der funktionellen Gruppen in den Komponenten a) und b) in der jeweiligen Komponente A).

Tabelle 1:

| Matrix | Isocyanat Komponente a) | Anteil (gr) | isocyanatreaktive Komponente b) | Anteil (gr) | NCO : OH | Katalysator in Lösung Komponente E) | Anteil (gr) | $n_{Ma}$ | $T_G$ (°C) |
|---|---|---|---|---|---|---|---|---|---|
| A1 | a1 | 26.6 | b1 | 73.0 | 1.02 : 1 | E1 | 0.400 | 1.455 | -61 |
| A2 | a2 | 1.68 | b2 | 13.3 | 1.02 : 1 | E1 | 0.045 | 1.464 | -67 |
| A3 | a3 | 15.4 | b3 | 84.2 | 1.02 : 1 | E1 | 0.400 | 1.482 | -64 |
| A4 | a2 | 1.72 | b4 | 13.3 | 1.02 : 1 | E1 | 0.045 | 1.459 | -64 |
| A5 | a4 | 1.47 | b4 | 13.50 | 1.02 : 1 | E1 | 0.060 | 1.460 | -64 |
| Komponente B | | | | | | | | $n_{Mo}$ | $T_G$ (°C) |
| B1 | | | | | | | | 1.576 | 20 |
| B2 | | | | | | | | 1.579 | -21 |
| B3 | | | | | | | | 1.543 | -32 |
| B4 | | | | | | | | 1.617 | 12 |
| B5 | | | | | | | | 1.584 | -16 |
| B6 | | | | | | | | 1.611 | 26 |
| Komponente D | | | | | | | | $n_{CA}$ | $T_G$ (°C) |
| D1 | | | | | | | | 1.384 | |
| D2 | | | | | | | | 1.356 | |

**Herstellung der Photopolymerformulierung mit UV-Initiator zur Bestimmung des Moduls $G_0$ und $G_{UV}$ der Photopolymeren vor und nach der UV Vernetzung.**

Zur Herstellung der Photopolymerformulierung zur Bestimmung des Moduls $G_{uv}$ der Photopolymeren nach UV

Vernetzung werden die Komponente B), die Komponente C4) (die bereits in der Komponente B) vorgelöst sein kann) sowie gegebenenfalls Additive in der isocyanatreaktiven Komponente b) gegebenenfalls bei 60 °C gelöst. Gegebenenfalls wird maximal 10 Minuten im Trockenschrank auf 60 °C erhitzt. Dann wird Isocyanat Komponente a) zugegeben und im Speedmixer 1 Minute gemischt. Im Folgenden wird eine Lösung der Komponente E1) in Butylacetat zugegeben und im Speedmixer erneut 1 Minute gemischt. Die Konzentration der Komponente E1) in Butylacetat beträgt 10 Gewichtsprozent. Von dieser Lösung wurden die in Tabelle 2 beschriebenen Mengen eingesetzt.

Tabelle 2 listet die untersuchten Beispiele der Photopolymerformulierungen zur Bestimmung des Moduls $G_{UV}$ der Photopolymeren nach UV Vernetzung, die nicht ausschließenden Charakter haben in ihrer Zusammensetzung auf. Diese Photopolymerformulierungen wurden entsprechend der Vorschrift, die im Abschnitt zur Bestimmung des Moduls $G_{UV}$ der Photopolymeren nach UV Vernetzung mittels eines Oszillationsrheometers beschrieben wurde hergestellt.

Tabelle 2:

| Photopolymer Formulierung mit UV Initiator (F) | Isocyanat Komponente a) | Anteil (gr) | isocyanatreaktive Komponente b) | Anteil (gr) | NCO : OH | Photopolymerisierbares Monomer 1 (Komponente B)) | Anteil (Gew. %) | Photopolymerisierbares Monomer 2 (Komponente B)) | Anteil (Gew. %) | Nicht photopolymerisierbare Komponente D) | Anteil (Gew. %) | UV-Initiator (gr) (Komponente C)) | Anteil (gr) | Katalysator in Lösung (Butylacetat) (Komponente E)) | Anteil (gr) |
|---|---|---|---|---|---|---|---|---|---|---|---|---|---|---|---|
| F I | a1 | 1.853 | b1 | 5.137 | 1.02 : 1 | B1 | X | B2 | 30.0 - X | | | C4 | 0.010 | E1 | 0.0280 |
| F II | a2 | 0.534 | b2 | 3.950 | 1.02 : 1 | B1 | X | B2 | 30.0 - X | D1 | 25.0 | C4 | 0.010 | E1 | 0.0350 |
| F III | a2 | 0.534 | b2 | 3.950 | 1.02 : 1 | B1 | X | B2 | 40.0 - X | D1 | 15.0 | C4 | 0.010 | E1 | 0.0350 |
| F IV | a3 | 0.707 | b3 | 3.783 | 1.02 : 1 | B1 | X | B2 | 30.0 - X | D2 | 25.0 | C4 | 0.010 | E1 | 0.0138 |
| F V | a3 | 0.707 | b3 | 3.783 | 1.02 : 1 | B1 | X | B2 | 40.0 - X | D2 | 15.0 | C4 | 0.010 | E1 | 0.0138 |
| F VI | a3 | 0.936 | b3 | 5.054 | 1.02 : 1 | B1 | X | B4 | 40.0 - X | | | C4 | 0.010 | E1 | 0.0095 |
| F VII | a2 | 0.534 | b2 | 3.950 | 1.02 : 1 | B1 | X | B2 | 30.0 - X | D2 | 25.0 | C4 | 0.010 | E1 | 0.0350 |
| F VIII | a2 | 0.534 | b2 | 3.950 | 1.02 : 1 | B1 | X | B2 | 40.0 - X | D2 | 15.0 | C4 | 0.010 | E1 | 0.0350 |
| F IX | a3 | 0.707 | b3 | 3.783 | 1.02 : 1 | B5 | X | B2 | 40.0 - X | D2 | 15.0 | C4 | 0.010 | E1 | 0.0138 |
| F X | a3 | 0.707 | b3 | 3.783 | 1.02 : 1 | B1 | X | B2 | 30.0 - X | D1 | 25.0 | C4 | 0.010 | E1 | 0.0138 |
| F XI | a3 | 0.707 | b3 | 3.783 | 1.02 : 1 | B1 | X | B2 | 40.0 - X | D1 | 15.0 | C4 | 0.010 | E1 | 0.0138 |
| F XII | a2 | 0.661 | b4 | 5.326 | 1.02 : 1 | B1 | X | B2 | 40.0 - X | | | C4 | 0.010 | E1 | 0.0587 |
| F XIII | a2 | 0.534 | b2 | 3.950 | 1.02 : 1 | B5 | X | B2 | 30.0 -X | D1 | 25.0 | C4 | 0.010 | E1 | 0.0350 |
| F XIV | a2 | 0.534 | b2 | 3.950 | 1.02 : 1 | B6 | X | B2 | 30.0 -X | D1 | 25.0 | C4 | 0.010 | E1 | 0.0350 |
| F A | a4 | 0.573 | b4 | 5.414 | 1.02 : 1 | B1 | X | B3 | 40.0 - X | | | C4 | 0.010 | E1 | 0.0295 |
| F B | a2 | 0.534 | b2 | 3.950 | 1.02 : 1 | B1 | X | B6 | 30.0 - X | D1 | 25.0 | C4 | 0.010 | E1 | 0.0350 |
| F C | a2 | 0.534 | b2 | 3.950 | 1.02 : 1 | B1 | X | B5 | 30.0 - X | D1 | 25.0 | C4 | 0.010 | E1 | 0.0350 |
| F D | a3 | 0.707 | b3 | 3.783 | 1.02 : 1 | B1 | X | B5 | 40.0 - X | D2 | 15.0 | C4 | 0.010 | E1 | 0.0138 |

**Herstellung der holographischen Medien basierend auf Photopolymerformulierung mit Photoinitiator zur Bestimmung des Brechungsindexkontrastes Δn.**

Es wurden aus den Photopolymerformulierungen holographische Medien hergestellt (siehe Tabelle 3), in denen sich das Photopolymer als Schicht zwischen Glasscheiben von je 1 mm Dicke befindet. Diese Art der holographischen Medien ist besonders geeignet, um deren Performance nach der im Abschnitt Messung der holographischen Eigenschaften DE und Δn der holographischen Medien mittels Zweistrahlinterferenz in Reflektionsanordnung beschriebenen Verfahren zu bestimmen und ist daher nicht begrenzend gemeint im Sinne der formulierten Ansprüche auf die holographischen Medien solange die verwendeten Photopolymerformulierung den beanspruchten Eigenschaften hinsichtlich Moduls $G_{UV}$ der Photopolymeren nach UV Vernetzung und der maximalenVariation von $\Delta n$ genügen.

**Beispielhafte Herstellung der holographischen Medien**

Zur Herstellung der holografischen Medien werden im Dunkeln die Komponente B), die Komponente C) (die bereits in der Komponente B) vorgelöst sein kann) sowie gegebenenfalls die Additive in der Isocyanat reaktiven Komponente b) gegebenenfalls bei 60 °C gelöst, dann werden Glasperlen der Größe 20 μm oder 10 μm (z. B. der Fa. Whitehouse Scientific Ltd, Waverton, Chester, CH3 7PB, United Kingdom) zugegeben und gründlich gemischt (Speedmixer). Gegebenenfalls wird maximal 10 Minuten im Trockenschrank auf 60 °C erhitzt. Dann wird die Isocyanat Komponente a) zugegeben und wieder im Speedmixer 1 Minute gemischt. Im Folgenden wird eine Lösung der Komponente E1) zugegeben und im Speedmixer erneut 1 Minute gemischt. Die erhaltene Mischung wird unter Rühren bei < 1 mbar maximal 30 Sekunden entgast, dann wird sie auf Glasplatten von 50 x 75 mm verteilt und diese je mit einer weiteren Glasplatte abgedeckt. Die Härtung der PU-Formulierung erfolgt unter 15 kg Gewichten über mehrere Stunden (gewöhnlich über Nacht). Teilweise werden die Medien in lichtdichter Verpackung noch 2 Stunden bei 60 °C nachgehärtet. Da unterschiedliche Formulierungen mit unterschiedlicher Ausgangsviskosität und unterschiedlicher Härtungsgeschwindigkeit der Matrix zu nicht immer gleichen Schichtdicken *d'* der Photopolymerschicht führen, wird *d'* anhand der Charakteristika der geschriebenen Hologramme für jede Probe separat ermittelt.

Tabelle 3:

| holographisches Medium (M) | Isocyanat Komponente a) | Anteil (gr) | isocyanatreaktive Komponente b) | Anteil (gr) | NCO : OH | Photopolymerisierbares Monomer 1 (Komponente B)) | Anteil (Gew. %) | Photopolymerisierbares Monomer 2 (Komponente B)) | Anteil (Gew. %) | Nicht photopolymerisierbare Komponente D) | Anteil (Gew. %) | Photoinitiator (Komponente C)) | Anteil (gr) | Katalysator in Lösung (Komponente E)) | Anteil (gr) | Entspricht Formulierung mit UV Initiator (F) |
|---|---|---|---|---|---|---|---|---|---|---|---|---|---|---|---|---|
| M I | a1 | 2.604 | b1 | 7.192 | 1.02 : 1 | B1 | X | B2 | 30.0 - X | | | C3 | 0.690 | E1 | 0.029 | F I |
| M II | a2 | 0.479 | b2 | 3.544 | 1.02 : 1 | B1 | X | B2 | 30.0 - X | D1 | 25.0 | C1 | 0.442 | E1 | 0.020 | F II |
| M III | a2 | 0.479 | b2 | 3.544 | 1.02 : 1 | B1 | X | B2 | 40.0 - X | D1 | 15.0 | C1 | 0.442 | E1 | 0.020 | F III |
| M IV | a3 | 0.623 | b3 | 3.401 | 1.02 : 1 | B1 | X | B2 | 30.0 - X | D2 | 25.0 | C1 | 0.441 | E1 | 0.020 | F IV |
| M V | a3 | 0.623 | b3 | 3.401 | 1.02 : 1 | B1 | X | B2 | 40.0 - X | D2 | 15.0 | C1 | 0.441 | E1 | 0.020 | F V |
| M VI | a3 | 0.854 | b3 | 4.669 | 1.02 : 1 | B1 | X | B4 | 40.0 - X | | | C1 | 0.442 | E1 | 0.020 | F VI |
| M VII | a2 | 0.479 | b2 | 3.544 | 1.02 : 1 | B1 | X | B2 | 30.0 - X | D2 | 25.0 | C1 | 0.442 | E1 | 0.020 | F VII |
| M VIII | a2 | 0.479 | b2 | 3.544 | 1.02 : 1 | B1 | X | B2 | 40.0 - X | D2 | 15.0 | C1 | 0.442 | E1 | 0.020 | F VIII |
| M IX | a3 | 0.630 | b3 | 3.404 | 1.02 : 1 | B5 | X | B2 | 40.0 - X | D2 | 15.0 | C1 | 0.445 | E1 | 0.006 | F IX |
| M X | a3 | 0.644 | b3 | 3.379 | 1.02 : 1 | B1 | X | B2 | 30.0 - X | D1 | 25.0 | C1 | 0.442 | E1 | 0.020 | F X |
| M XI | a3 | 0.644 | b3 | 3.379 | 1.02 : 1 | B1 | X | B2 | 40.0 - X | D1 | 15.0 | C1 | 0.442 | E1 | 0.020 | F XI |
| M XII | a2 | 0.633 | b4 | 4.890 | 1.02 : 1 | B1 | X | B2 | 40.0 - X | | | C2 | 0.442 | E1 | 0.020 | F XII |
| M XIII | a2 | 0.479 | b2 | 3.544 | 1.02 : 1 | B5 | X | B2 | 30.0 -X | D1 | 25.0 | C1 | 0.442 | E1 | 0.020 | F XIII |
| M XIV | a2 | 0.479 | b2 | 3.544 | 1.02 : 1 | B6 | X | B2 | 30.0 -X | D1 | 25.0 | C1 | 0.442 | E1 | 0.020 | F XIV |
| M A | a4 | 0.553 | b4 | 4.970 | 1.02 : 1 | B1 | X | B3 | 40.0 - X | | | C2 | 0.422 | E1 | 0.020 | F A |
| M B | a2 | 0.479 | b2 | 3.544 | 1.02 : 1 | B1 | X | B6 | 30.0 - X | D1 | 25.0 | C1 | 0.422 | E1 | 0.020 | F B |
| M C | a2 | 0.479 | b2 | 3.544 | 1.02 : 1 | B1 | X | B5 | 30.0 - X | D1 | 25.0 | C1 | 0.422 | E1 | 0.020 | F C |
| M D | a3 | 0.623 | b3 | 3.401 | 1.02 : 1 | B1 | X | B5 | 40.0 - X | D2 | 15.0 | C1 | 0.441 | E1 | 0.020 | F D |

**Ergebnisse aus $G_{UV}$ und Variation von $\Delta n$ kombiniert.**

Folgende Messwerte für $G_0$ (MPa), $G_{UV}$ (MPa), $\Delta n$ und Variation von $\Delta n$ (%) bei der Dosis E (mJ/cm$^2$) wurden erhalten und sind in Tabelle 4a und 4b dargestellt. Die mit * gekennzeichneten $\Delta n$ Werte wurden statt mit $\lambda$ = 633 nm mit $\lambda$ = 532 nm gemessen.

**Tabelle 4a:**

| Beispiel Typ | Holographische Medium (M) | $\Delta n$ | Variation von $\Delta n$ | Entspricht Formulierung mit UV Initiator (F) | Gesamter Anteil der Komponenten B) im Photopolymer (%) | $G_0$ | $G_{UV}$ | E | $n_{Ms}-n_{CA}$ | $n_{Mo}-n_{Ms}$ | $T_G$ von Komponente A) |
|---|---|---|---|---|---|---|---|---|---|---|---|
| Erfindungsgemäßes Beispiel 1; Figur 4 | M I | 0.011 - 0.012 | 9 | F I | 30 | 0.09 - 0.19 | 0.35 - 38 | 4 - 36 | > +0.121 | | -61 |
| Erfindungsgemäßes Beispiel 1; Figur 4 | M I | 0.013* - 0.015* | 15 | F I | 30 | 0.09 - 0.19 | 0.35 - 38 | 16- 128 | > +0.121 | | -61 |
| Erfindungsgemäßes Beispiel 2; Figur 5 | M II | 0.033 - 0.039 | 18 | F II | 30 | 0.06 - 0.11 | 0.22 - 55 | 4 - 36 | > +0.112 | 0.080 | -67 |
| Erfindungsgemäßes Beispiel 3; Figur 6 | M III | 0.036 - 0.041 | 14 | F III | 40 | 0.05 - 0.09 | 0.23 - 157 | 4 - 36 | > +0.112 | 0.080 | -67 |
| Erfindungsgemäßes Beispiel 4; Figur 7 | M IV | 0.024 - 0.035 | 46 | F IV | 30 | 0.32 - 0.57 | 0.47 - 47 | 4 - 36 | > +0.094 | 0.126 | -64 |
| Erfindungsgemäßes Beispiel 5; Figur 8 | M V | 0.031 - 0.040 | 29 | F V | 40 | 0.31 - 0.41 | 0.53 - 61 | 4 - 36 | > +0.094 | 0.126 | -64 |
| Erfindungsgemäßes Beispiel 6; Figur 9 | M VI | 0.008 - 0.011 | 38 | F VI | 40 | 0.10 - 0.59 | 0.32 - 96 | 4 - 36 | > +0.094 | | -64 |
| Erfindungsgemäßes Beispiel 7; Figur 10 | M VII | 0.032 - 0.039 | 22 | F VII | 30 | 0.08 - 0.15 | 0.18 - 46 | 4 - 36 | > +0.112 | 0.108 | -67 |
| Erfindungsgemäßes Beispiel 8; Figur 11 | M VIII | 0.035 - 0.042 | 17 | F VIII | 40 | 0.04 - 0.11 | 0.15 - 54 | 4 - 36 | > +0.112 | 0.108 | -67 |
| Erfindungsgemäßes Beispiel 9; Figur 12 | M IX | 0.026 - 0.040 | 54 | F IX | 40 | 0.29 - 0.44 | 0.53 - 25 | 4 - 36 | > +0.102 | 0.126 | -64 |
| Erfindungsgemäßes Beispiel 10; Figure 13 | M X | 0.028 - 0.038 | 37 | F X | 30 | 0.27 - 0.62 | 0.47 - 46 | 4 - 36 | > +0.094 | 0.098 | -64 |
| Erfindungsgemäßes Beispiel 11; Figur 14 | M XI | 0.028 - 0.041 | 46 | F XI | 40 | 0.20 - 0.54 | 0.39 - 94 | 4 - 36 | > +0.094 | 0.098 | -64 |
| Erfindungsgemäßes Beispiel 12; Figur 15 | M XII | 0.017* - 0.021* | 24 | F XII | 40 | 0.03 - 0.08 | 0.70 - 147 | 4 - 36 | > +0.094 | | -64 |
| Erfindungsgemäßes Beispiel 13; Figur 16 | M XIII | 0.030 - 0.037 | 23 | F XIII | 30 | 0.05 - 0.09 | 0.22 - 27 | 4 - 36 | > +0.120 | 0.080 | -67 |
| Erfindungsgemäßes Beispiel 14; Figur 17 | M XIV | 0.028 - 0.037 | 32 | F XIV | 30 | 0.01 - 0.09 | 0.22 - 15 | 4 - 36 | > +0.120 | 0.080 | -67 |

Tabelle 4b:

| Beispiel Typ | Holographische Medium (M) | $\Delta n$ | Variation von $\Delta n$ | Entspricht Formulierung mit UV Initiator (F) | Gesamter Anteil der Komponenten B) im Photopolymer (%) | $G_0$ | $G_{UV}$ | E | $n_{Ma}-n_{CA}$ | $n_{Mo}-n_{Ma}$ | $T_G$ von Komponente A) |
|---|---|---|---|---|---|---|---|---|---|---|---|
| Gegenbeispiel.: A; Figur A | M A | 0.022* - 0.024* | 9 | F A | 40.0 | 0.01 - 0.02 | 30 - 223 | 8 - 64 | > +0.083 | | -64 |
| Gegenbeispiel.: B; Figur B | M B | 0.028 - 0.035 | 25 | F B | 30.0 | 0.01 - 0.09 | 15 - 55 | 4 - 32 | > +0.147 | 0.080 | -67 |
| Gegenbeispiel.: C; Figur C | M C | 0.029 - 0.035 | 21 | F C | 30.0 | 0.05 - 0.09 | 12 - 55 | 4 - 32 | > +0.120 | 0.080 | -67 |
| Gegenbeispiel.: D; Figur D | M D | n.g. | n.g. | F D | 40.0 | 0.31 - 0.40 | 46 - 176 | 4 - 32 | > +0.098 | 0.126 | -64 |

Die gefundenen Werte für die Variation von $\Delta n$ der holographischen Medien und den Modul $G_{UV}$ der Photopolymerformulierungen nach UV Vernetzung bei der Variation des relativen Gehaltes an multifunktionellem Monomer in einer Mischung mit einem monofunktionellen Monomer (Komponenten B)) zeigen eindrucksvoll, wie sich die mechanischen Eigenschaften der Photopolymere nach UV Belichtung von weichgummiartiger Konsistenz bis zu hoher mechanischer Härte einstellen lassen ohne die holographische Performance $\Delta n$ signifikant zu beeinflussen. In Mischungen aus nur multifunktionellen Schreibmonomeren lassen sich keine weichen Einstellungen des mechanischen Moduls realisieren!

Die gefundenen Ergebnisse werden nochmals in den folgenden Abbildungen Figur 4 bis Figur 19 und Figur A bis Figur D verdeutlicht. Diese Figuren zeigen den Verlauf von $G_{uv}$ (offene Symbole, linke y-Achse) für die Formulierungen mit dem UV-Initiator F, $\Delta n$ (mit $\lambda$ = 633 nm aufgezeichnete Hologramme, geschlossene Symbole, rechte y-Achse) und / oder $\Delta n$ (mit $\lambda$ = 532 nm aufgezeichnete Hologramme, halboffene Symbole, rechte y-Achse) für die Medien M mit dem Anteil der photopolymerisierbaren multifunktionellen Komponente B an der Gesamtformulierung. Der summarische Anteil der multifunktionellen Komponente B und der monofunktionellen Komponente B an der Gesamtformulierung ist den Tabellen 4a und 4b zu entnehmen.

## Patentansprüche

1. Verfahren zur Herstellung von belichteten, holographischen Medien enthaltend eine Photopolymer-Formulierung mit einem Modul $G_{uv}$ im Bereich zwischen 0.1 und 160 MPa und einem $\Delta n \geq 0{,}008$ bei dem

   i. eine Photopolymer-Formulierung umfassend,

      A) Matrixpolymere als amorphes Netzwerk
      B) eine Kombination eines monofunktionellen Schreibmonomers und eines multifunktionellen Schreibmonomers
      C) ein Photoinitiatorsystem
      D) optional eine nicht photopolymerisierbare Komponente

E) gegebenenfalls Katalysatoren, Radikalstabilisatoren, Lösungsmittel, Additive sowie andere Hilfs- und / oder Zusatzstoffe

bereit gestellt,
ii. die Photopolymer-Formulierung in die Form von Medien gebracht
iii. die Medien einem holographischen Belichtungsexperiment unterzogen werden, um das Hologramm zu schreiben und
iv. das Medium als ganzes mit UV-Strahlung belichtet wird um das Hologramm zu fixieren

wobei es sich bei den Schreibmonomeren um Acrylat- und / oder Methacrylat-funktionalisierte Verbindungen handelt, der Gesamtgehalt an Schreibmonomeren in der Photopolymer-Formulierung ≥ 30 Gew.-% und ≤ 45 Gew.-% ist, die unbelichtete Photopolymer-Formulierung einen Modul $G_0$ < 0,7 MPa aufweist und der Modul $G_{UV}$ der belichteten Photopolymer Formulierung im vorgesehenen Bereich zwischen 0.1 und 160 MPa über das Verhältnis des relativen Anteils des monofunktionellen Schreibmonomers zu dem relativen Anteil des multifunktionellen Schreibmonomer am Gesamtschreibmonomergehalt derart eingestellt wird, dass ein hoher Modul durch einen hohen relativen Anteil des multifunktionellen Schreibmonomers und ein niedriger Modul durch einen hohen relativen Anteil des monofunktionellen Schreibmonomers am Gesamtschreibmonomergehalt realisiert wird.

**2.** Verfahren nach Anspruch 1, **dadurch gekennzeichnet, dass** die belichteten, holographischen Medien einen Modul $G_{uv}$ im Bereich zwischen 0,3 und 40, bevorzugt zwischen 0,7 und 15 MPa aufweisen.

**3.** Verfahren nach einem der Ansprüche 1 oder 2, **dadurch gekennzeichnet, dass** die Schreibmonomere und die Matrixpolymere so ausgewählt werden, dass der Brechungsindex jedes der beiden Schreibmonomere entweder um mindestens 0,05 Einheiten größer als der Brechungsindex der Matrixpolymere oder der Brechungsindex jedes der beiden Schreibmonomere mindestens um 0,05 Einheiten kleiner als der Brechungsindex der Matrixpolymere ist.

**4.** Verfahren nach einem der Ansprüche 1 bis 3, **dadurch gekennzeichnet, dass** die Matrixpolymere Polyurethane sind, die insbesondere durch Umsetzung einer NCO-Gruppen tragenden Komponente und einer NCO-reaktiven Komponente, wobei mindestens eine der beiden Komponenten ein Equivalentgewicht von mehr als 200 g/Mol, bevorzugt von mehr als 350 g/Mol aufweist und weiterhin bevorzugt im Polymerrückgr at keine zyklischen Strukturen auftreten.

**5.** Verfahren nach Anspruch 4, **dadurch gekennzeichnet, dass** die Polyurethane im ausreagierten Zustand eine Glastemperatur $T_G$ < -45°C aufweisen.

**6.** Verfahren nach einem der Ansprüche 1 bis 5, **dadurch gekennzeichnet, dass** das monofunktionelle Schreibmonomer die allgemeine Formel (II)

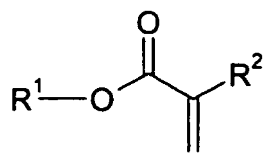

(II)

hat, in der $R^1$, $R^2$ Wasserstoff und / oder unabhängig voneinander lineare, verzweigte, cyclische oder heterocyclische unsubstituierte oder gegebenenfalls auch mit Heteroatomen substituierte organische Reste sind. und das monofunktionelle Schreibmonomer bevorzugt eine Glastemperatur $T_G$ < 15°C aufweist.

**7.** Verfahren nach einem der Ansprüche 1 bis 6, **dadurch gekennzeichnet, dass** das multifunktionelle Schreibmonomer die allgemeine Formel (III)

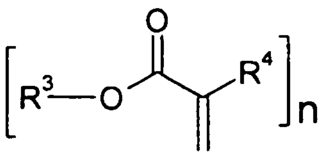

(III)

hat, in der n≥2 und n≤4 ist und $R^3$, $R^4$ Wasserstoff und / oder unabhängig voneinander lineare, verzweigte, cyclische oder heterocyclische unsubstituierte oder gegebenenfalls auch mit Heteroatomen substituierte organische Reste sind und das multifunktionelle Schreibmonomer bevorzugt einen Brechungsindex von $n_D^{20}$ > 1.50 aufweist.

8. Verfahren nach einem der Ansprüche 1 bis 7 **dadurch gekennzeichnet, dass** die Photopolymer-Formulierung zusätzlich Weichmacher enthält.

9. Verfahren nach Anspruch 8, **dadurch gekennzeichnet, dass** der Weichmacher so ausgewählt wird, dass der Brechungsindex des Weichmachers mindestens um 0,05 Einheiten kleiner als der Brechungsindex der Matrixpolymere ist, wenn beide Schreibmonomere höhere Brechungsindizes als die Matrixpolymere besitzen und der Brechungsindex des Weichmachers um mindestens 0,05 Einheiten größer als der Brechungsindex der Matrixpolymere ist, wenn beide Schreibmonomere Brechungsindizes kleiner als der Brechungsindex der Matrixpolymere besitzen.

10. Verfahren nach einem der Ansprüche 8 oder 9, **dadurch gekennzeichnet, dass** als Weichmacher Urethane der allgemeinen Formel (VI)

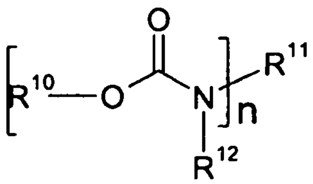

(VI)

verwendet werden, bei denen n≥1 und n≤8 ist und $R^{10}$, $R^{11}$, $R^{12}$ Wasserstoff und / oder unabhängig voneinander lineare, verzweigte, cyclische oder heterocyclische unsubstituierte oder gegebenenfalls auch mit Heteroatomen substituierte organische Reste sind, wobei bevorzugt mindestens einer der Reste $R^{10}$, $R^{11}$, $R^{12}$ mit wenigstens einem Fluoratom substituiert ist und besonders bevorzugt $R^{10}$ ein organischer Rest mit mindestens einem Fluoratom ist.

11. Verfahren nach einem der Ansprüche 1 bis 10 **dadurch gekennzeichnet, dass** das Photoinitiatorsystem einen anionischen, kationischen oder neutralen Farbstoff und einen Coinitiator umfasst.

12. Verfahren nach einem der Ansprüche 1 bis 11, **dadurch gekennzeichnet, dass** das Δn von einzelnen belichteten, holographischen Medien mit unterschiedlichen Anteilen an monofunktionellen und multifunktionellen Schreibmonomeren um weniger als 55% variiert, wobei die Variation wie folgt zu berechnen ist: $(\Delta n_{max} - \Delta n_{min}) \Delta n_{min} \cdot 100\%$.

13. Verfahren nach einem der Ansprüche 1 bis 12, **dadurch gekennzeichnet, dass** eine Schicht aus der Photopolymer-Formulierung im Schritt ii) mit einem Substrat verbunden wird.

14. Verfahren nach Anspruch 13, **dadurch gekennzeichnet, dass** die Schicht aus der Photopolymer-Formulierung mit einem weiteren Substrat verbunden wird.

15. Verfahren nach einem der Ansprüche 13 oder 14, **dadurch gekennzeichnet, dass** die Beschichtung und das oder die Substrate durch Laminieren oder Verkleben miteinander verbunden werden.

16. Belichtetes holographisches Medium, erhältlich nach einem Verfahren gemäß einem der Ansprüche 1 bis 15.

## Claims

1. Process for the production of exposed, holographic media containing a photopolymer formulation having a modulus $G_{UV}$ in the range between 0.1 and 160 MPa and a $\Delta n \geq 0.008$, in which

   i. a photopolymer formulation comprising

      A) matrix polymers as an amorphous network
      B) a combination of a monofunctional writing monomer and a polyfunctional writing monomer
      C) a photoinitiator system
      D) optionally a non-photopolymerisable component
      E) optionally catalysts, free radical stabilisers, solvents, additives and other auxiliaries and/or additives is provided,

   ii. the photopolymer formulation is brought into the form of media
   iii. the media are subjected to a holographic exposure experiment in order to record the hologram and
   iv. the medium as a whole is exposed to UV radiation in order to fix the hologram,

   the writing monomers being acrylate- and/or methacrylate-functionalised compounds, the total content of writing monomers in the photopolymer formulation being ≥ 30% by weight and ≤ 45% by weight, the unexposed photopolymer formulation having a modulus $G_0$ of < 0.7 MPa and the modulus $G_{UV}$ of the exposed photopolymer formulation being adjusted in the intended range between 0.1 and 160 MPa via the ratio of the relative proportion of the monofunctional writing monomer to the relative proportion of the polyfunctional writing monomer, based on the total writing monomer content, in such a way that a high modulus is realised by a high relative proportion of the polyfunctional writing monomer and a low modulus by a high relative proportion of the monofunctional writing monomer, based on the total writing monomer content.

2. Process according to Claim 1, **characterized in that** the exposed, holographic media have a modulus $G_{UV}$ in the range between 0.3 and 40, preferably between 0.7 and 15, MPa.

3. Process according to either of Claims 1 and 2, **characterized in that** the writing monomers and the matrix polymers are chosen so that the refractive index of each of the two writing monomers is either at least 0.05 unit greater than the refractive index of the matrix polymers or the refractive index of each of the two writing monomers is at least 0.05 unit less than the refractive index of the matrix polymers.

4. Process according to any of Claims 1 to 3, **characterized in that** the matrix polymers are polyurethanes which can be prepared in particular by reaction of a component carrying NCO groups and an NCO-reactive component, at least one of the two components having an equivalent weight of more than 200 g/mol, preferably of more than 350 g/mol, and furthermore preferably no cyclic structures occurring in the polymer backbone.

5. Process according to Claim 4, **characterized in that** the polyurethanes in the reacted state have a glass transition temperature $T_G$ of < - 45°C.

6. Process according to any of Claims 1 to 5, **characterized in that** the monofunctional writing monomer has the general formula (II)

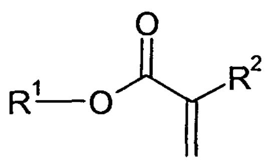

(II)

   in which $R^1$, $R^2$ are hydrogen and/or, independently of one another, linear, branched, cyclic or heterocyclic organic radicals which are unsubstituted or optionally also substituted by heteroatoms, and the monofunctional writing monomer preferably has a glass transition temperature $T_G$ of < 15°C.

**7.** Process according to any of Claims 1 to 6, **characterized in that** the polyfunctional writing monomer has the general formula (III)

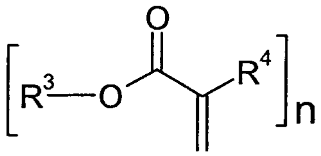

(III)

in which n is ≥ 2 and n is ≤ 4 and $R^3$, $R^4$ are hydrogen and/or, independently of one another, linear, branched, cyclic or heterocyclic organic radicals which are unsubstituted or optionally also substituted by heteroatoms, and the polyfunctional writing monomer preferably has a refractive index of $n_D^{20} > 1.50$.

**8.** Process according to any of Claims 1 to 7, **characterized in that** the photopolymer formulation additionally contains plasticizer.

**9.** Process according to Claim 8, **characterized in that** the plasticizer is chosen so that the refractive index of the plasticizer is at least 0.05 unit less than the refractive index of the matrix polymers if both writing monomers have higher refractive indices than the matrix polymers, and the refractive index of the plasticizer is at least 0.05 unit greater than the refractive index of the matrix polymers if both writing monomers have refractive indices less than the refractive index of the matrix polymers.

**10.** Process according to either of Claims 8 and 9, **characterized in that** plasticizers used are urethanes of the general formula (VI)

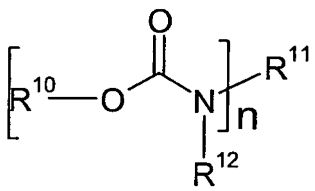

(VI)

in which n is ≥ 1 and n is ≤ 8 and $R^{10}$, $R^{11}$, $R^{12}$ are hydrogen and/or, independently of one another, linear, branched, cyclic or heterocyclic organic radicals which are unsubstituted or optionally also substituted by heteroatoms, preferably at least one of the radicals $R^{10}$, $R^{11}$, $R^{12}$ being substituted by at least one fluorine atom and particularly preferably $R^{10}$ being an organic radical having at least one fluorine atom.

**11.** Process according to any of Claims 1 to 10, **characterized in that** the photoinitiator system comprises an anionic, cationic or neutral dye and a coinitiator.

**12.** Process according to any of Claims 1 to 11, **characterized in that** the □n of individual exposed, holographic media having different proportions of monofunctional and polyfunctional writing monomers varies by less than 55%, the variation being calculated as follows: (□$n_{max}$ - □$n_{min}$) / □□$n_{min}$ ·100%.

**13.** Process according to any of Claims 1 to 12, **characterized in that** a layer of the photopolymer formulation in step ii) is bonded to a substrate.

**14.** Process according to Claim 13, **characterized in that** the layer of the photopolymer formulation is bonded to a further substrate.

**15.** Process according to either of Claims 13 and 14, **characterized in that** the coating and the substrate or substrates are bonded to one another by lamination or adhesive bonding.

**16.** Exposed holographic medium, obtainable by a process according to any of Claims 1 to 15.

## Revendications

**1.** Procédé de fabrication d'agents éclairés, holographiques, contenant une formulation de photopolymère présentant un module $G_{uv}$ dans la plage entre 0,1 et 160 MPa et un $\Delta n \geq 0{,}008$ dans lequel

i. on prépare une formulation de photopolymère, comprenant

A) des polymères de matrice en tant que réseau amorphe
B) une combinaison d'un monomère d'enregistrement monofonctionnel et d'un monomère d'enregistrement multifonctionnel
C) un système photo-initiateur
D) éventuellement un composant non photopolymérisable
E) le cas échéant des catalyseurs, des stabilisateurs de radicaux, des solvants, des additifs ainsi que d'autres adjuvants et/ou substances auxiliaires

ii. on amène la formulation de photopolymère sous forme d'agents
iii. on soumet les agents à une expérience d'éclairage holographique, pour enregistrer l'hologramme, et
iv. on éclaire l'agent dans sa totalité par un rayonnement UV pour fixer l'hologramme

où il s'agit, pour les monomères d'enregistrement, de composés fonctionnalisés par acrylate et/ou méthacrylate, la teneur totale en monomères d'enregistrement dans la formulation de photopolymère est ≥ 30% en poids et ≤ 45% en poids, la formulation de photopolymère non éclairée présente un module $G_0$ < 0,7 MPa et le module $G_{uv}$ de la formulation de photopolymère éclairée est réglé dans la plage prévue entre 0,1 et 160 MPa via le rapport de la proportion relative du monomère d'enregistrement monofonctionnel à la proportion relative du monomère d'enregistrement multifonctionnel par rapport à la teneur totale en monomère d'enregistrement en ce qu'un module plus élevé est réalisé par une proportion relative élevée du monomère d'enregistrement multifonctionnel et un module plus petit est réalisé par une proportion relative élevée du monomère d'enregistrement monofonctionnel, par rapport à la teneur totale en monomère d'enregistrement.

**2.** Procédé selon la revendication 1, **caractérisé en ce que** les agents éclairés, holographiques présentent un module $G_{uv}$ dans la plage entre 0,3 et 40, de préférence entre 0,7 et 15 MPa.

**3.** Procédé selon l'une quelconque des revendications 1 ou 2, **caractérisé en ce que** les monomères d'enregistrement et les polymères de matrice sont choisis de manière telle que l'indice de réfraction de chacun des deux monomères d'enregistrement est soit supérieur d'au moins 0,05 unité à l'indice de réfraction des polymères de matrice, soit l'indice de réfraction de chacun des deux monomères d'enregistrement est inférieur d'au moins 0,05 unité à l'indice de réfraction des polymères de matrice.

**4.** Procédé selon l'une quelconque des revendications 1 à 3, **caractérisé en ce que** les polymères de matrice sont des polyuréthanes, qui peuvent en particulier être préparés par transformation d'un composant portant des groupes NCO et d'un composant réactif avec NCO, au moins un des deux composants présentant un poids équivalent supérieur à 200 g/mole, de préférence supérieur à 350 g/mole et l'épine dorsale polymère ne présentant de préférence pas de structures cycliques.

**5.** Procédé selon la revendication 4, **caractérisé en ce que** les polyuréthanes présentent, à l'état réagi, une température de transition vitreuse $T_G$ < - 45°C.

**6.** Procédé selon l'une quelconque des revendications 1 à 5, **caractérisé en ce que** le monomère d'enregistrement monofonctionnel présente la formule générale (II)

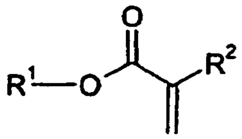

(II)

dans laquelle $R^1$, $R^2$ représentent hydrogène et/ou, indépendamment l'un de l'autre, des radicaux organiques linéaires, ramifiés, cycliques ou hétérocycliques, non substitués ou le cas échéant également substitués par des hétéroatomes et le monomère d'enregistrement monofonctionnel présente de préférence une température de transition vitreuse $T_G < 15°C$.

7. Procédé selon l'une quelconque des revendications 1 à 6, **caractérisé en ce que** le monomère d'enregistrement multifonctionnel présente la formule générale (III)

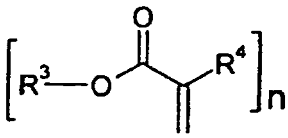

(III)

dans laquelle $n \geq 2$ et $n \leq 4$ et $R^3$, $R^4$ représentent hydrogène et/ou, indépendamment l'un de l'autre, des radicaux organiques linéaires, ramifiés, cycliques ou hétérocycliques, non substitués ou le cas échéant également substitués par des hétéroatomes et le monomère d'enregistrement multifonctionnel présente de préférence un indice de réfraction $n_D^{20} > 1,50$.

8. Procédé selon l'une quelconque des revendications 1 à 7, **caractérisé en ce que** la formulation de photopolymère contient en outre des plastifiants.

9. Procédé selon la revendication 8, **caractérisé en ce que** le plastifiant est choisi de manière telle que l'indice de réfraction du plastifiant est inférieur d'au moins 0,05 unité à l'indice de réfraction des polymères de matrice, lorsque les deux monomères d'enregistrement présentent des indices de réfraction supérieurs à celui des polymères de matrice et l'indice de réfraction du plastifiant est supérieur d'au moins 0,05 unité à l'indice de réfraction des polymères de matrice, lorsque les deux monomères d'enregistrement présentent des indices de réfraction inférieurs à l'indice de réfraction des polymères de matrice.

10. Procédé selon l'une quelconque des revendications 8 ou 9, **caractérisé en ce qu'**on utilise, comme plastifiant, des uréthanes de formule générale (VI)

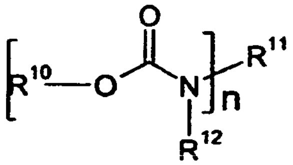

(VI)

dans laquelle $n \geq 1$ et $n \leq 8$ et $R^{10}$, $R^{11}$, $R^{12}$ représentent hydrogène et/ou, indépendamment l'un de l'autre, des radicaux organiques linéaires, ramifiés, cycliques ou hétérocycliques, non substitués ou le cas échéant également substitués par des hétéroatomes, de préférence au moins un des radicaux $R^{10}$, $R^{11}$, $R^{12}$ étant substitué par au moins un atome de fluor et $R^{10}$ représentant de manière particulièrement préférée un radical organique comprenant au moins un atome de fluor.

11. Procédé selon l'une quelconque des revendications 1 à 10, **caractérisé en ce que** le système de photo-initiateur comprend un colorant anionique, cationique ou neutre et un co-initiateur.

12. Procédé selon l'une quelconque des revendications 1 à 11, **caractérisé en ce que** le Δn d'agents holographiques

individuels éclairés, comprenant des proportions différentes de monomères d'enregistrement monofonctionnels et multifonctionnels varie de moins de 55%, la variation étant calculée comme suit : $(\Delta n_{max} - \Delta n_{min}) / \Delta n_{min} * 100\%$.

**13.** Procédé selon l'une quelconque des revendications 1 à 12, **caractérisé en ce qu'**une couche de la formulation de photopolymère dans l'étape ii) est assemblée à un substrat.

**14.** Procédé selon la revendication 13, **caractérisé en ce que** la couche de la formulation de photopolymère est assemblée à un autre substrat.

**15.** Procédé selon l'une quelconque des revendications 13 ou 14, **caractérisé en ce que** le revêtement et le ou les substrats sont assemblés l'un à l'autre par laminage ou collage.

**16.** Agent holographique éclairé, pouvant être obtenu selon un procédé selon l'une quelconque des revendications 1 à 15.

Figur 1:

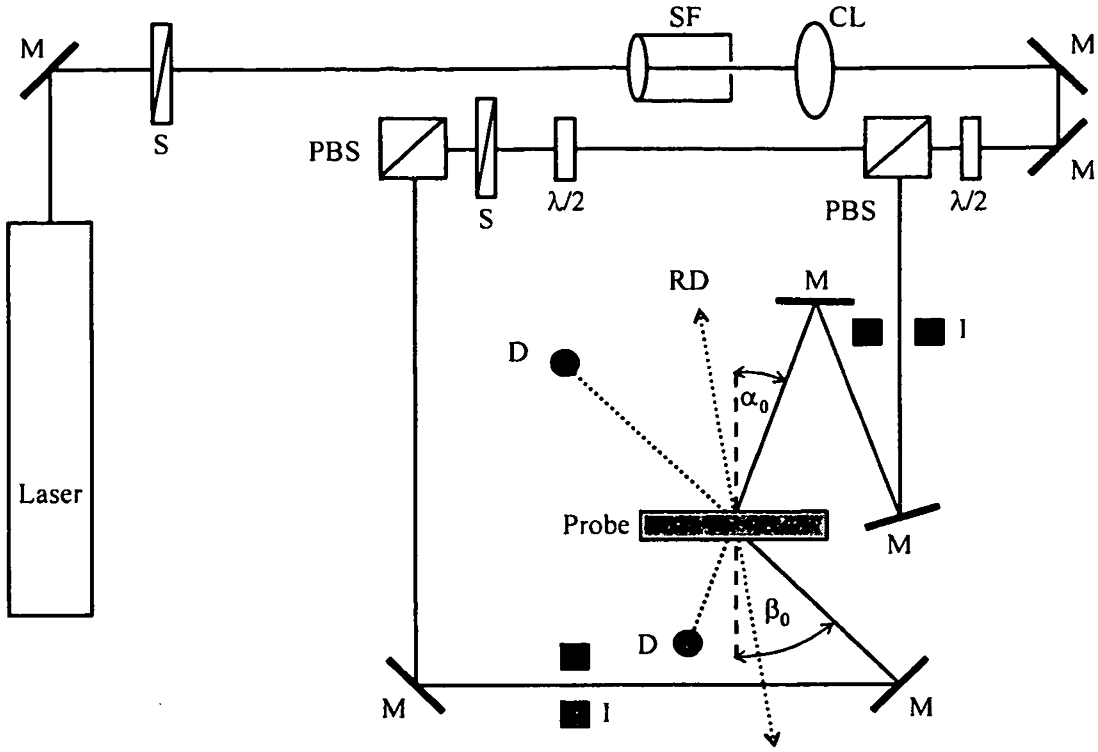


Figur 2:

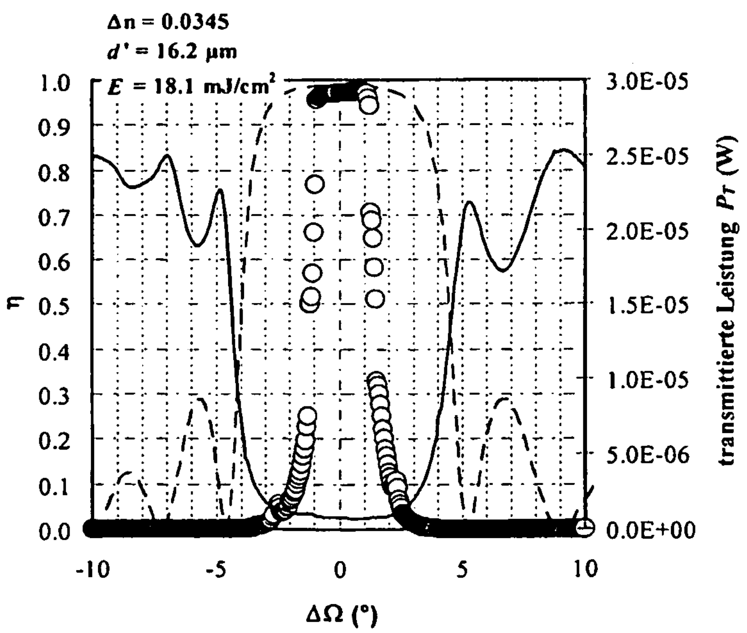

Figur 3:

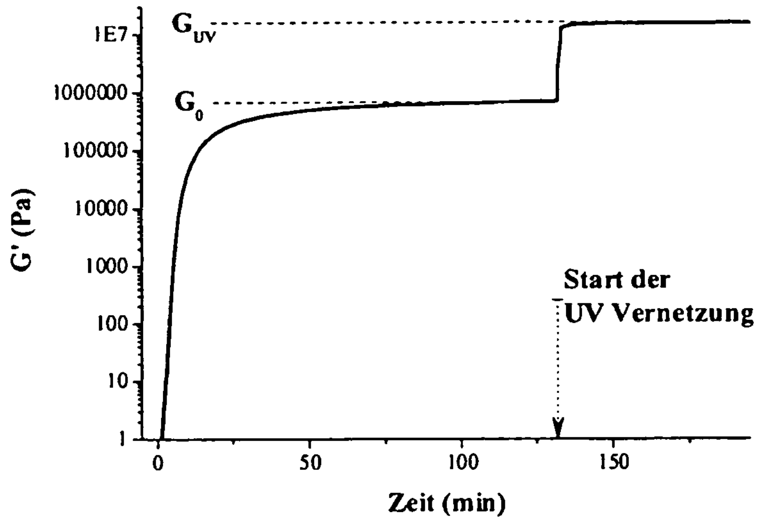


Figur 4:

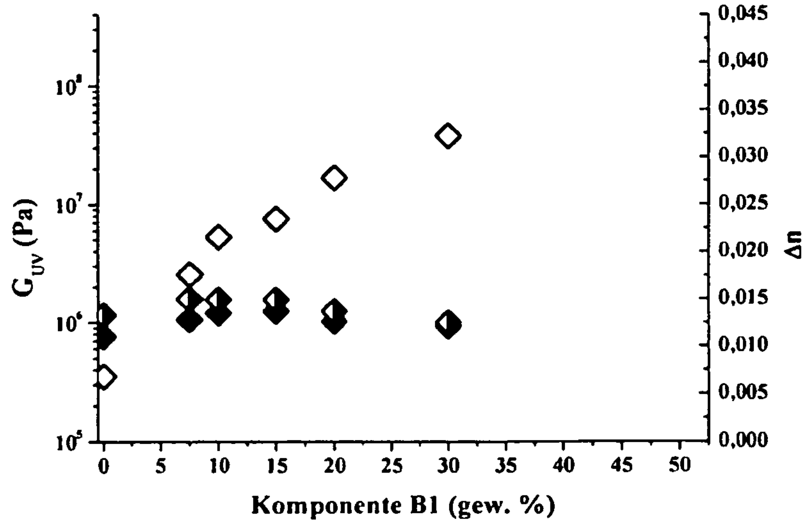

Figur 5:

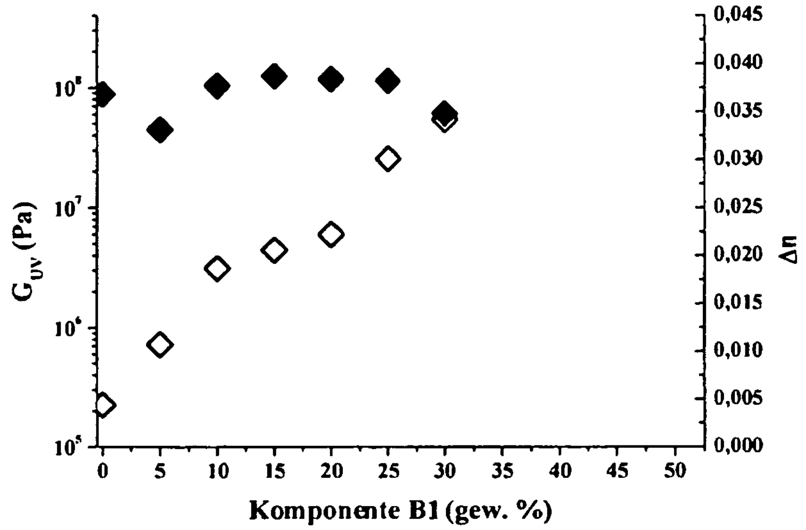


Figur 6:

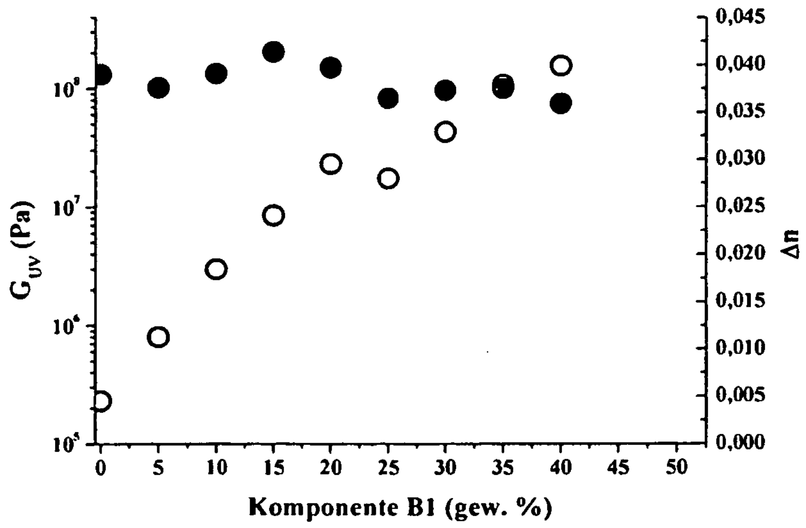

Figur 7:

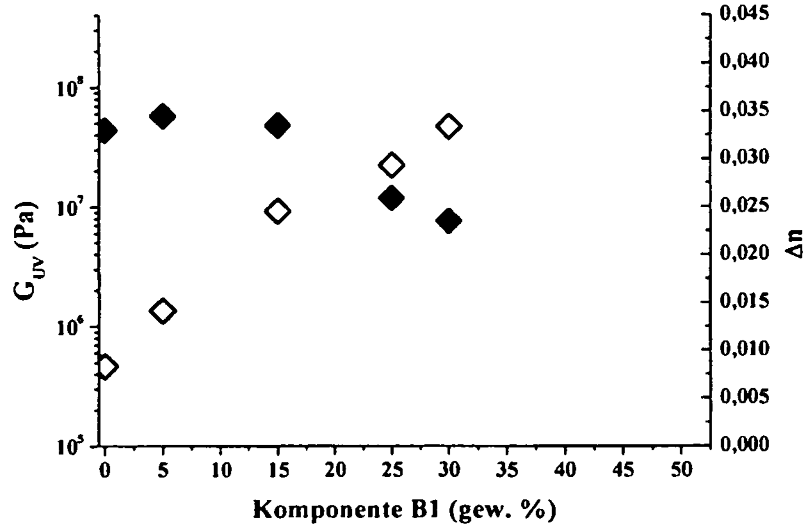


Figur 8:

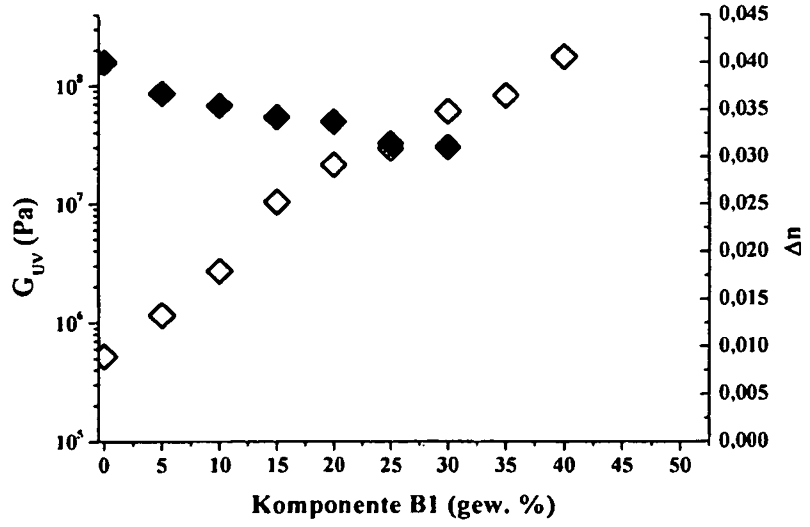

Figur 9:

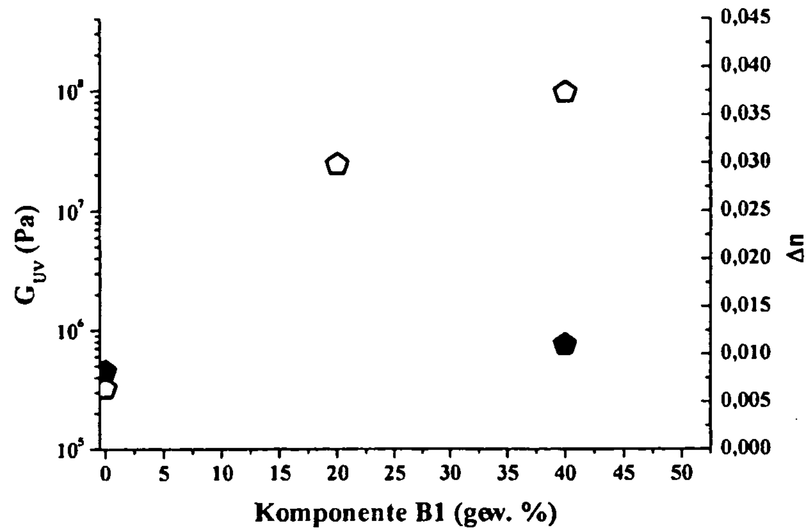


Figur 10:

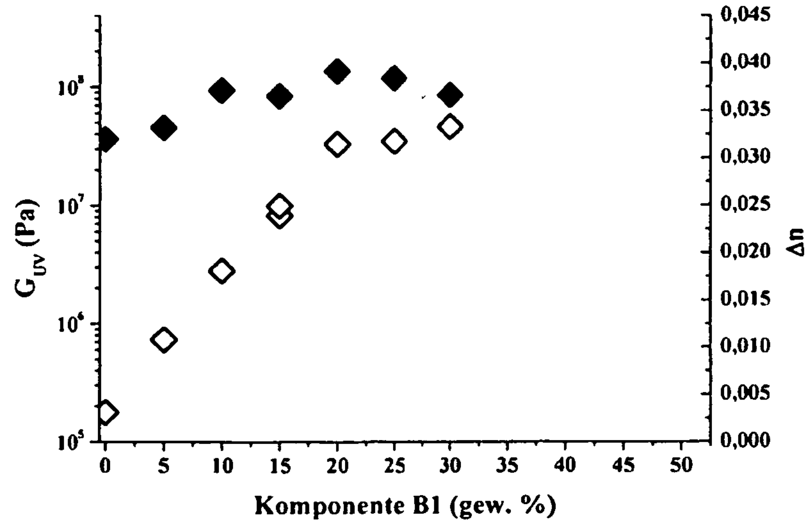

Figur 11:

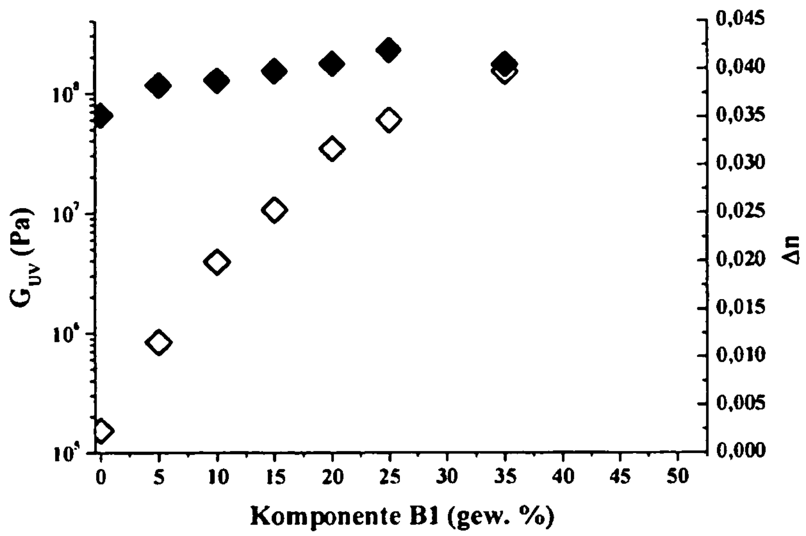


Figur 12:

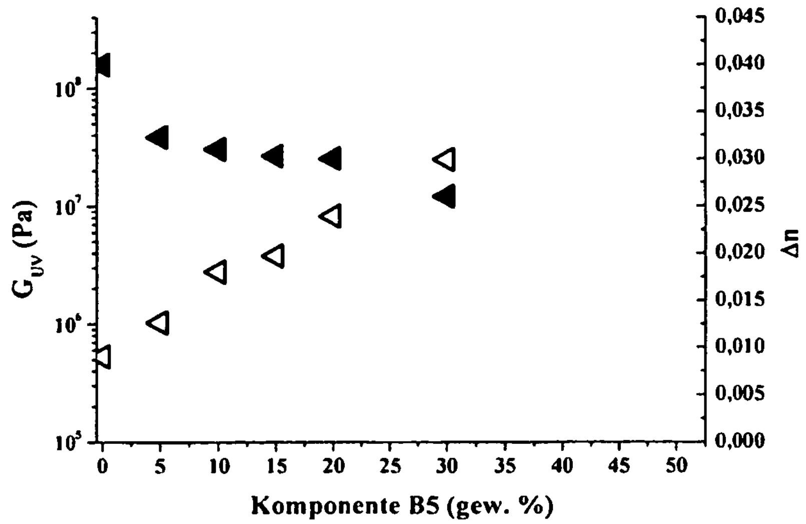

Figur 13:

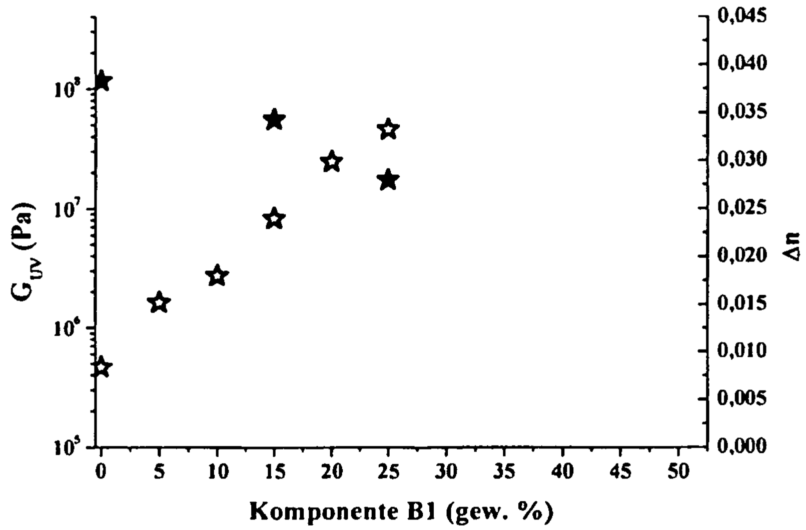


Figur 14:

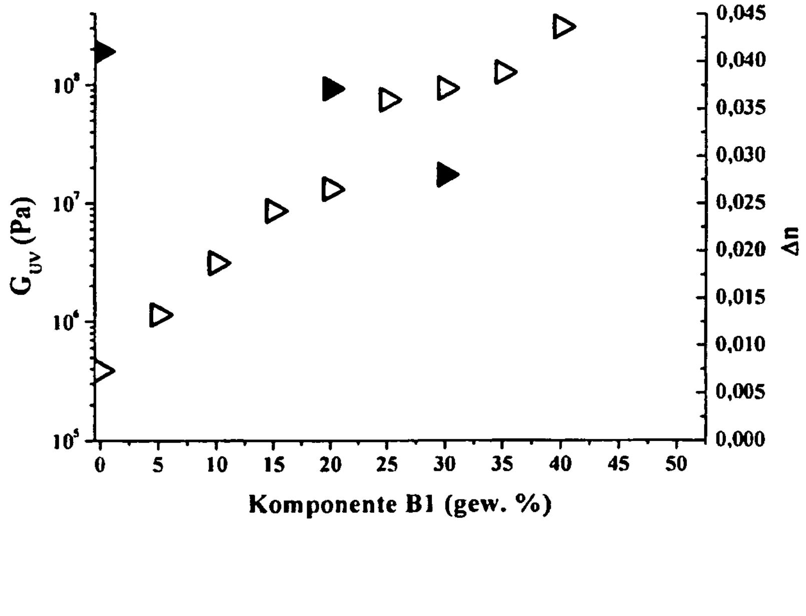

Figur 15:

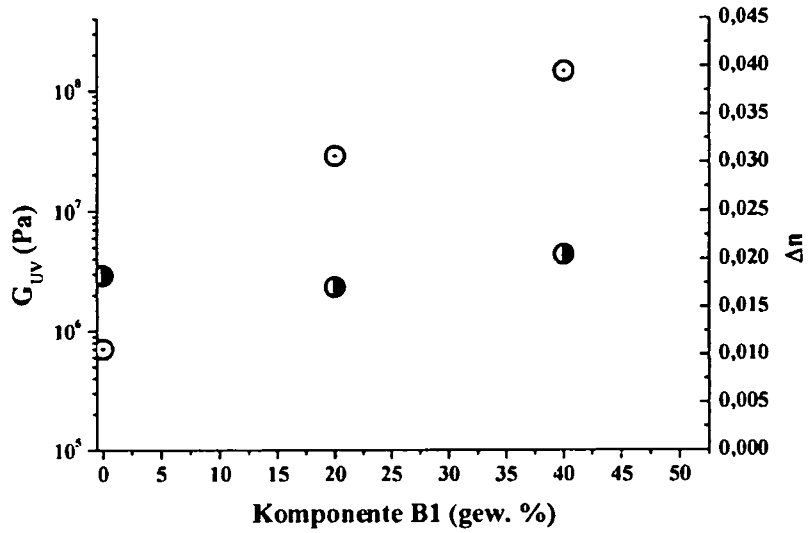


Figur 16:

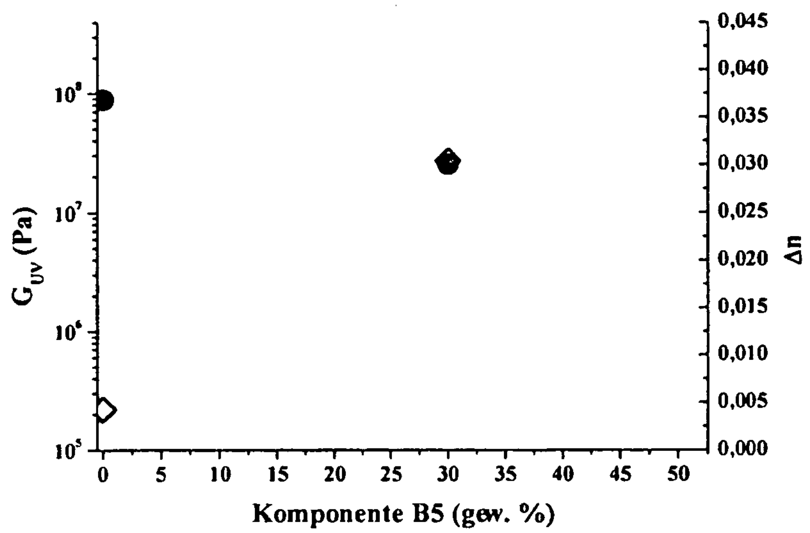

Figur 17:

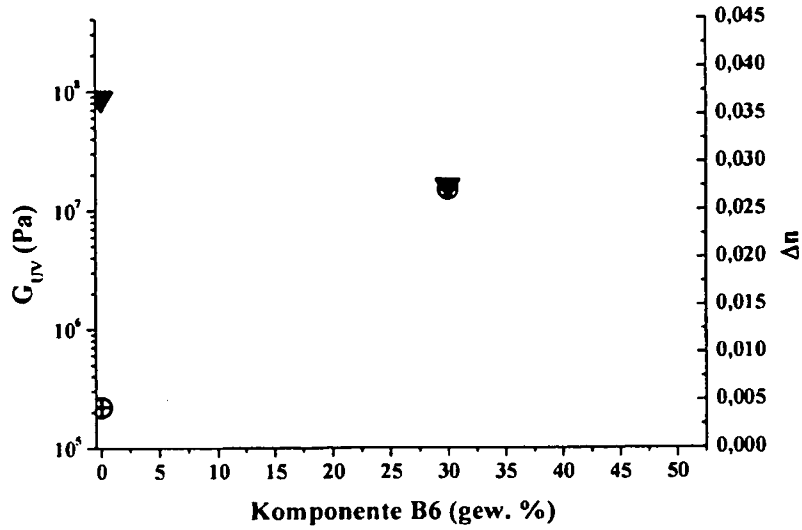


Figur A:

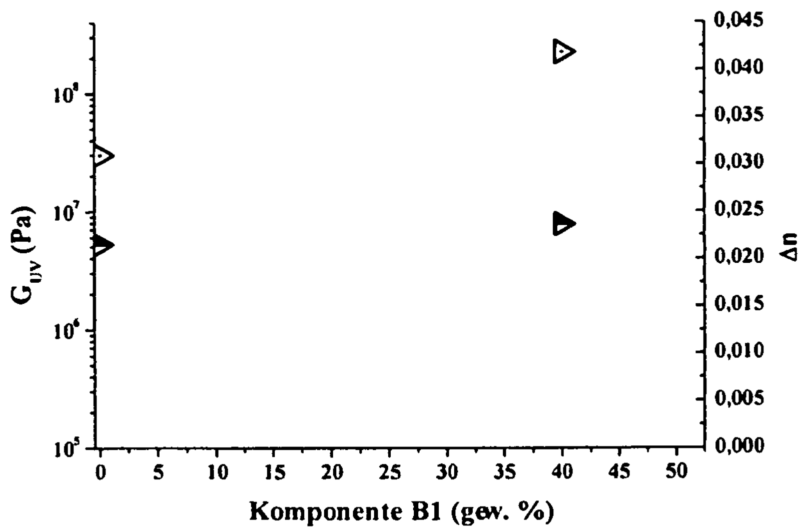

Figur B:

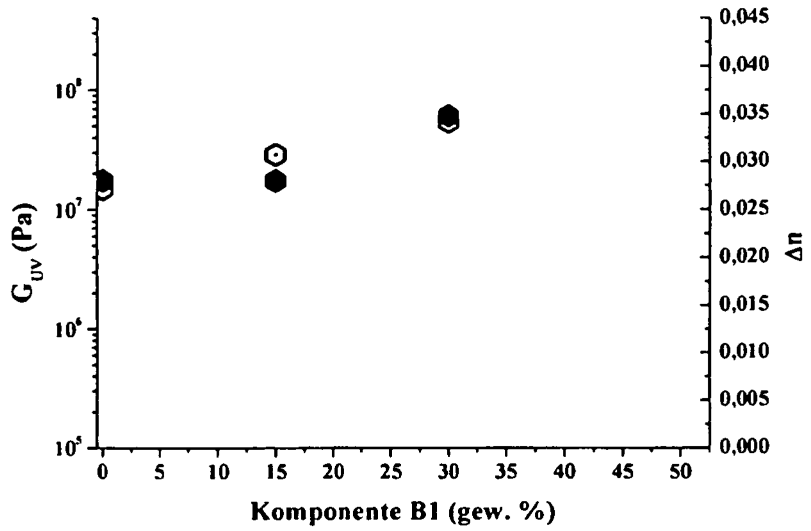


Figur C:

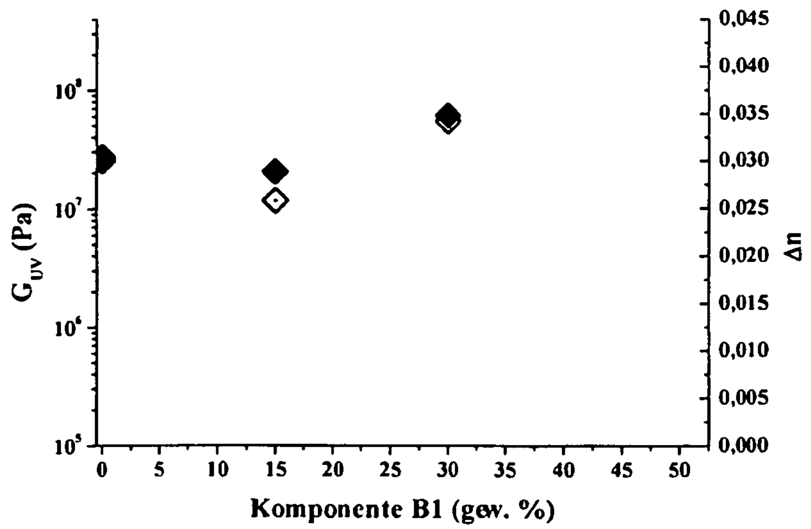

**Figur D:**

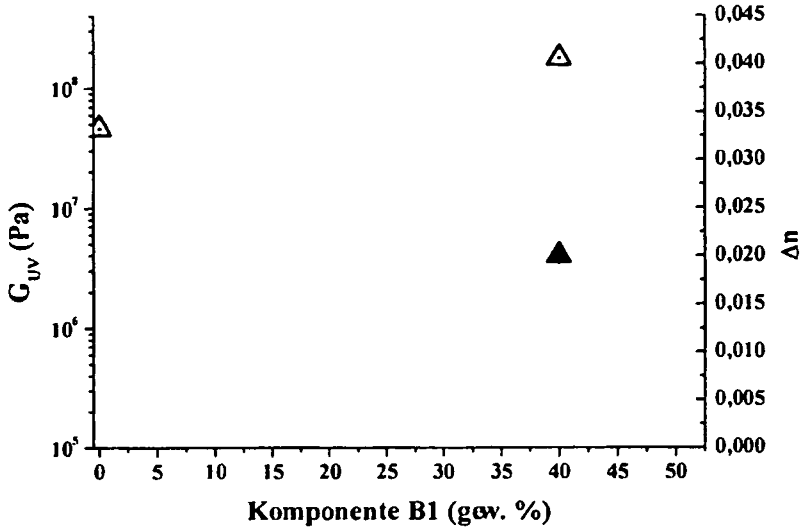

$10^8$
$10^7$
$10^6$
$10^5$
$G_{UV}$ (Pa)
0,045
0,040
0,035
0,030
0,025
0,020
0,015
0,010
0,005
0,000
Δn
0 5 10 15 20 25 30 35 40 45 50
Komponente B1 (gew. %)

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2008125229 A1
- US 5470813 A
- EP 700949 A
- EP 743093 A
- EP 761708 A
- WO 9740086 A
- WO 9816310 A
- WO 0047649 A
- EP 09009651 A
- EP 09002180 A
- EP 0223587 A


### In der Beschreibung aufgeführte Nicht-Patentliteratur


- **Cunningham et al.** *RadTech'98 North America UV/EB Conference Proceedings,* 19. April 1998
- **Kutal et al.** *Macromolecules,* 1991, vol. 24, 6872
- **Yamaguchi et al.** *Macromolecules,* 2000, vol. 33, 1152
- **Neckers et al.** *Macromolecules,* 2000, vol. 33, 7761
- **Li et al.** *Polymeric Materials Science and Engineering,* 2001, vol. 84, 139
- **Dektar et al.** *J. Org. Chem.,* 1990, vol. 55, 639
- *J. Org. Chem.,* 1991, vol. 56, 1838
- **Crivello et al.** *Macromolecules,* 2000, vol. 33, 825
- **Gu et al.** *Am. Chem. Soc. Polymer Preprints,* 2000, vol. 41 (2), 1266
- **Hua et al.** *Macromolecules,* 2001, vol. 34, 2488-2494
- Chemistry & Technology of UV & EB Formulations For Coatings, Inks & Paints. SITA Technology, 1991, vol. 3, 61-328
- **Houben-Weyl.** Methoden der organischen Chemie. Georg Thieme Verlag, 1961, vol. XIV/1, 433ff
- **H. Kogelnik.** *The Bell System Technical Journal,* November 1969, vol. 48 (9), 2909-2947